# EUROPEAN PATENT SPECIFICATION

(11) **EP 0 650 593 B1**
(45) Date of publication and mention of the grant of the patent: **26.02.2003**
(21) Application number: 93917238.3
(22) Date of filing: 16.07.1993
(51) Int. Cl.: G01N 27/00, G01N 27/416

(54) **SYSTEM FOR DETECTING ATOMIC OR MOLECULAR SPECTRA OF A SUBSTANCE, AND/OR THRESHOLD PHENOMENA ASSOCIATED WITH THE SAME**
SYSTEM ZUM FESTSTELLEN VON ATOM- ODER MOLEKULARSPEKTREN UND/ODER DAMIT VERBUNDENEN SCHWELLENERSCHEINUNGEN
SYSTEME DE DETECTION DU SPECTRE ATOMIQUE OU MOLECULAIRE ET/OU DES PHENOMENES DE SEUIL ASSOCIES

(30) Priority: 17.07.1992 US 916165; 20.11.1992 US 979597; 30.04.1993 US 56348; 15.07.1993 US 92133; 15.07.1993 US 92016
(43) Date of publication of application: 03.05.1995
(73) Proprietor: THE PENN STATE RESEARCH FOUNDATION, University Park, PA 16802 (US); BIOTECHNOLOGY RESEARCH AND DEVELOPMENT CORPORATION, Peoria, IL 61604 (US)
(72) Inventor: WEISS, Paul, S., State College, PA 16803 (US); STRANICK, Stephan, J., State College, PA 16801 (US)
(74) Representative: Luckhurst, Anthony Henry William
(86) International application number: US9306718
(87) International publication number: WO94002840

(56) References cited:
- US-A- 3 566 262
- US-A- 4 941 753
- REVIEW OF SCIENTIFIC INSTRUMENTS. vol. 63, no. 9 , September 1992 , NEW YORK US pages 4080 - 4085 B.MICHEL ET AL 'scanning surface harmonic microscopy : scanning probe microscopy based on microwave field-induced harmonic generation.'
- ULTRAMICROSCOPY vol. 42-44, no. A , July 1992 , NETHERLANDS pages 379 - 387 W.SEIFERT ET AL 'scanning tunneling microscopy at microwave frequencies'
- REVIEW OF SCIENTIFIC INSTRUMENTS. vol. 63, no. 11 , November 1992 , NEW YORK US pages 5366 - 5372 G.S.POPIROV ; R.N.SCHINDLER 'a new impedence spectrometer for the investigation of electrochemical systems'
- PHYSICAL REVIEW LETTERS vol. 62, no. 19 , 8 May 1989 , USA pages 2285 - 2288 G.P.KOCHANSKI 'nonlinear alternating-current tunneling microscopy' cited in the application
- PHYSICAL REVIEW LETTERS vol. 65, no. 3 , July 1990 , NEW YORK US pages 281 - 284 F.GUINEA ; N.GARCIA 'scanning tunneling microscopy,resonant tunneling, and counting electrons: a quantum standard of current'

## Description

### Background of the Invention

This invention relates to a system for detecting the threshold and spectra of substances at the atomic or molecular level. The threshold and spectra of substances at the atomic or molecular level may be detected by detecting either the current through or voltage across the substances or reflection of an electrical signal from the substances such as bulk electrical insulators or other materials. Multiple sources and detection frequencies are proposed for use in detecting threshold phenomena associated with and/or atomic or molecular spectra of one or more substances.

With the advent of instruments such as the scanning tunneling microscope (STM), it is now possible to investigate the structure, spectra and dynamics of biological molecules and membranes as well as other substances at the atomic or molecular level. While more than a thousand STM's have been in operation and the instrument has sparked great interest in spectroscopy, the actual headway that has been made in this area remains rather modest. Thus, Bob Wilson and co-workers at IBM Almaden have made some progress in distinguishing closely related adsorbed surface species in STM images. G. Meijer et al., Nature 348, 621 (1990). In "NonLinear Alternating-Current Tunneling Microscopy," Kochanski, Physical Review Letters, 62:19, pp. 2285-2288 (May 1989), a method for scanning tunneling microscopy is described, where a non-linear alternating current (AC) technique is used that allows stable control of a microscope tip above insulating surfaces where direct current (DC) tunneling is not possible.

The STM has a counter electrode on which the sample to be investigated is placed and another electrode in the shape of a microscope probe with a tip placed at a small distance away from the sample surface. A DC or a low frequency AC signal is then applied across the pair of electrodes. The probe tip is then moved across the sample surface in a scanning operation and the changes in the current or voltage across the electrodes are monitored to detect the characteristics of the sample.

The distance between the probe tip and the counter electrode/sample is controlled by a piezoelectric, driver in one of two possible modes: a constant current mode and a constant height mode. The current or voltage detected between the pair of electrodes is used to derive a control signal for controlling the piezoelectric driver in the constant current mode to change the distance between the probe tip and the sample so as to maintain a constant current between the electrodes. The voltage that has been applied to the piezoelectric driver in order to keep the tunneling current constant indicates the height of the tip z(x,y) as a function of the position (x,y) of the probe tip over the sample surface. A record of such voltages therefore indicates the topographical image of the sample surface.

The constant current mode can be used for surfaces which are not necessarily flat on an atomic scale. A disadvantage of the constant current mode is the response time required for the electronic and piezoelectric components in the feedback loop for controlling the piezoelectric driver; this response time sets relatively low upper limits for the scan speed.

To increase the scan speed considerably, the feedback loop response is slowed or turned off completely so that the probe tip is rapidly scanned at a constant average distance to the counter electrode irrespective of the contours of the sample surface. The rapid variations in the tunneling current are recorded as a function of location (x,y) to yield the topographic information of the sample surface. This is known as the constant height mode referring to the fact that the probe tip is maintained at a constant average distance from the counter electrode.

The constant height mode is advantageous over the constant current mode since it has a faster scan rate not limited by the response time of the feedback loop. Consequently, slow dynamic processes on surfaces can be studied. On the other hand, it is more difficult to extract the topographic height information from the variations of the tunneling current. Furthermore, unless the sample is atomically flat, the tip might crash into a surface protrusion of the sample. For a more complete description of the two operating modes of the STM's, please see "Scanning Tunneling Microscopy I," by H.-J. Guntherodt R. Wiesendanger (Eds.), Springer-Verlag, pp. 5-6.

In the article referenced above, Kochanski proposes to investigate insulating films by applying an AC current between the electrodes at frequency ω and the current between the electrodes at 3ω is detected. The AC signal is generated using a 2 GHz resonant cavity so that the frequency or frequencies of the signal applied to the STM electrodes and detected must be fixed in the scanning operation performed by Kochanski.

U.S. Patent No.4,941,753 discloses a scanning tunnelling microscopy control apparatus wherein a sample to be investigated is spaced from a measurement tip that is maintained as close as possible to the sample thereby equalizing thermal levels in the tip of the sample. Energy is applied to the sample being investigated and either a steady state or dynamic junction potential is measured. This potential is representative of the local sample temperature.

U.S. Patent No.3,566,262 discloses a molecular spectrometer operating on tunnelling electron-principles. A sample substance is observed via its molecular rotational levels by way of a barrier effect created from doping a semiconductor so that it has a low conductance at its surface. This provides a high number of tunnelling electrons at low voltages. The problem with this type of arrangement is that all measurements are made at single frequencies.

A paper entitled "Scanning Tunnelling Miscroscopy at Microware Frequencies" by W.Seifert published in Ultramiscroscopy 42 to 44 (1992) 379 to 387 discloses a scanning tunnel miscroscope using a generation of higher harmonics when applying microwaves. The paper discusses the detection of harmonics for given fields wherein the elastic deformation of a tip and a substrate under investigation are observed. Such a system employs a cavity and therefore measures only at a single frequency at a time. The source used is not programmably tunable.

### SUMMARY OF THE INVENTION

One aspect of the invention is directed to an apparatus for detecting a change in amplitude of a current or voltage transmitted through or reflected from, a substance, said change being related to threshold phenomena associated with the substance and/or atomic or molecular spectra of the substance, the apparatus comprising: a source for providing a time varying electrical signal; at least one electrode for coupling said signal to a substance; and a device connected to the at least one electrode for measuring the amplitude of the current or voltage of an electrical signal at the at least one electrode. The apparatus is characterised in that the electrical signal provided by the source has at least one frequency in the range of about 1 to 30 GHz, and in that the device measures amplitude changes of the current or voltage of the electrical signal at the at least one electrode substantially simultaneously at two or more frequencies in a predetermined spectrum of frequencies.

Another aspect of this invention is a method used for detecting a change in amplitude of a current or voltage transmitted through, or reflected from, a substance, said change being related to threshold phenomena associated with the substance and/or atomic or molecular spectra of the substance, the method, comprising: providing a time varying electrical input signal to at least one electrode in the vicinity of the substance; and measuring amplitude changes of the current or voltage of transmitted or reflected electrical signal at the at least one electrode. The method is characterised in that said time varying electrical signal has a frequency in the range of about 1 to 30 GHz and in that said amplitude changes are measured substantially simultaneously at two or more frequencies in a predetermined spectrum of frequencies.

These above aspects of the invention are based on the observation that threshold phenomena associated with and/or atomic or molecular spectra of a substance can be investigated by detecting the current or voltage across the electrodes of the STM at frequencies over a predetermined spectrum of frequencies simultaneously instead of at only a single frequency as in Kochanski's work.

Where the substance placed between the tip of the STM and a conductor is a bulk insulator such as a salt crystal or mineral or living cells in a large organism such as an animal, it may not be possible to pass a current through the insulator and detect the current therethrough or the voltage across it. Further aspects of the invention enable threshold phenomena associated with such substances to be measured as described below.

The apparatus may further comprise a device connected to the electrode for measuring the amplitude of the reflected signal from the electrode to detect threshold phenomena associated with and/or atomic or molecular spectra of the substance. In a preferred embodiment, the measuring device measures the amplitudes of the reflected signal at the electrode over a predetermined spectrum of frequencies to detect threshold phenomena associated with and/or atomic or molecular spectra or electrochemical response of the substance. Also in a preferred embodiment, the reflected signal may be used for comparison with a reference signal to derive an error signal fed back to control the distance between the electrode and the substance in a constant current mode.

Another aspect of this invention is a method used for detecting a substance, said method comprising:
placing at least one electrode in contact with the substance or near the substance so that the at least one electrode is spaced apart from the substance by a gap;
providing an time varying electrical input signal to the electrode, so that said input signal is coupled to said substance, said substance reflecting said input signal to generate a reflected signal;

In this embodiment, the measuring may measure the amplitudes of the current or voltage across the electrodes over a predetermined spectrum of frequencies to detect threshold phenomena associated with and/or atomic or molecular spectra of the substance. Also in this embodiment, the method may further comprise comparing the reflected signal with a reference signal to derive an error signal and using the error signal to control the distance between the electrode and the substance in a constant current mode.

The above aspects of the invention are based on the observations that threshold phenomena associated with and/or atomic or molecular spectra or electrochemical response of a substance such as a bulk insulator can be investigated by using an electrode to couple a current or voltage directly or across a gap to the substance and detecting the reflected signal at the electrode. In this manner, it is unnecessary to measure the tunnelling current which limits measurement to thin insulators or other small samples that can be placed on an electrical conductor. In the same manner as that described above for other embodiments, the reflected signal may be measured at a STM electrode at frequencies over a predetermined spectrum of frequencies simultaneoulsy instead of at only a single frequency as in Kochanski's work.

Furthermore, in a preferred embodiment, if a tunable source (e.g., between about 1-30 GHz) is used for providing the time varying signal applied to the electrode or electrodes, the frequency of the signal applied may be tuned to an optimal value for measuring. the amplitudes of the current through or voltage across or of the reflected signal over the predetermined spectrum. In addition, by varying the frequency of the electrical signal, it is possible to detect rates of motion of charges, or structural re-arrangements, in the sample or substance tested.

In a preferred embodiment, the frequency of the signal is maintained substantially constant but the amplitude of the signal is varied and the current through or voltage across the sample or substance or the signal reflected therefrom at a selected frequency is monitored so that a sudden change in current or voltage indicates a threshold of the substance. After the optimal frequency of the electrical signal to be applied is determined, the tunable source is preferably tuned to such frequency and the STM may then be used to scan a sample for differentiating different surface species or for obtaining images of the surfaces of the sample.

The system of this invention is applicable not only to STM's but also to other detection schemes such as the Coulomb blockade device for measuring threshold phenomena or rates of change of electrical charges in the device, and to electrochemical cells for detecting dynamic information concerning electrochemical changes. In the preferred embodiment, a spectrum analyzer or a network analyzer is used for measuring the amplitudes of current through or voltage across the electrodes or of reflected signals over a predetermined spectrum of frequencies. Other measurement devices that can be used instead of a spectrum analyzer or a network analyzer include a lock-in amplifier, a microwave transition analyzer measuring at one frequency and its harmonics, a vector voltmeter, or a power meter with tunable filters. Where the time varying signal applied is an AC signal, and where the amplitudes of the current or voltage at the fundamental frequency of the AC electrical signal applied are measured, a network analyser is used to perform the measurements.

As an improvement to the above described schemes, multiple source and detection frequencies may be used for detecting threshold phenomena or atomic or molecular spectra.

A further embodiment of the detection apparatus is characterised in that the electrode detects a reflected electrical signal from the substance in response to time varying signal and in that the device measures amplitude changes of the current or voltage of the reflected electrical signal.

The time varying signal preferably includes components of at least two different frequencies that are individually or in various combinations characteristic of the at least two substances. The apparatus further comprises a circuit substantially simultaneously measuring the amplitudes of the currents or voltages across the substances at said at least two frequencies or their harmonics, or their sums and differences or various combinations thereof to detect threshold phenomena associated with and/or atomic or molecular spectra of the at least two substances.

Another embodiment comprises a tunable source for providing a time varying electrical signal at a selected frequency.

The signal preferably includes components of at least two different frequencies. The source includes at least two signal generators, each providing an electrical signal with frequencies in a frequency band including one of the at least two frequencies, and a combiner connecting the generators. The apparatus further comprises a device substantially simultaneously measuring the amplitudes of the current or voltage across the substance at frequencies including said at least two frequencies or various combinations thereof.

A further embodiment comprises a programmably tunable source for providing a time varying electrical input signal at a selected frequency; and an electrode spaced apart from the substance by a gap, said electrode coupling said input signal to a substance across said gap and detecting across said gap a reflected electrical signal from the substance in response to said input signal.

### Brief Description of the Drawings

Fig. 1 is a schematic diagram of a high frequency STM for imaging insulator surfaces using throughput attenuation with a network analyzer, or using non-linear harmonic recording with a spectrum analyzer.

Fig. 2A is a graphical illustration of the modulated bias voltage used in the apparatus of Fig. 1 over time, where the dashed line shows the voltage threshold for a second electron to hop to (or from) the surface.

Fig. 2B is a graphical illustration of the resulting current due to the effect of the second electron versus time when the bias voltage of Fig. 2A is applied in the apparatus of Fig. 1.

Fig. 3 is a graphical illustration of the Fourier spectra detected when an AC signal is applied across a substance to be measured. The Fourier spectra includes three different graphs for three different substances having different thresholds.

Fig. 4 is a graphical illustration of the ratio of the current or voltage measured to the voltage or current applied to the STM electrodes across a predetermined spectrum when an AC signal of 2 GHz is applied across a substance.

Fig. 5 is a graphical illustration of the ratio of the current or voltage measured to the voltage or current applied to the STM electrodes across a predetermined spectrum when an AC signal of 2.5 GHz is applied across a substance.

Fig. 6 is a graphical illustration of the ratio of the current or voltage measured at the fundamental frequency to the voltage or current applied to the STM electrodes at the fundamental frequency to electrodes across a substance.

Fig. 7 is a plot of the alternating current STM image of the edge of a pore on a surface showing the microscopic details of the surfaces scanned.

Fig. 8 is a schematic diagram of an electrochemical cell and a circuit diagram of a potential controlling and current measuring instrument for monitoring the electrochemical cell in a conventional arrangement.

Fig. 9 is a schematic diagram of a Coulomb blockade device to illustrate the invention.

Fig. 10 is a schematic diagram of a high frequency STM and multiple oscillators and combiners for providing an AC signal of multiple frequencies and a network or spectrum analyzer for measuring simultaneously at multiple frequencies to illustrate the invention.

Fig. 11A is a schematic diagram of a high frequency STM for imaging insulator surfaces by measuring the reflected signal with a network analyzer, or a spectrum analyzer to illustrate the invention of this application.

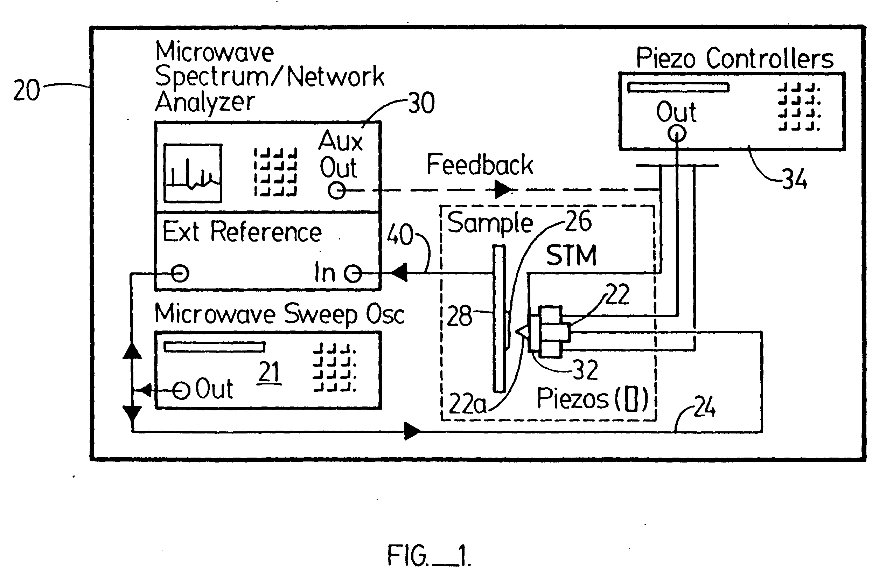

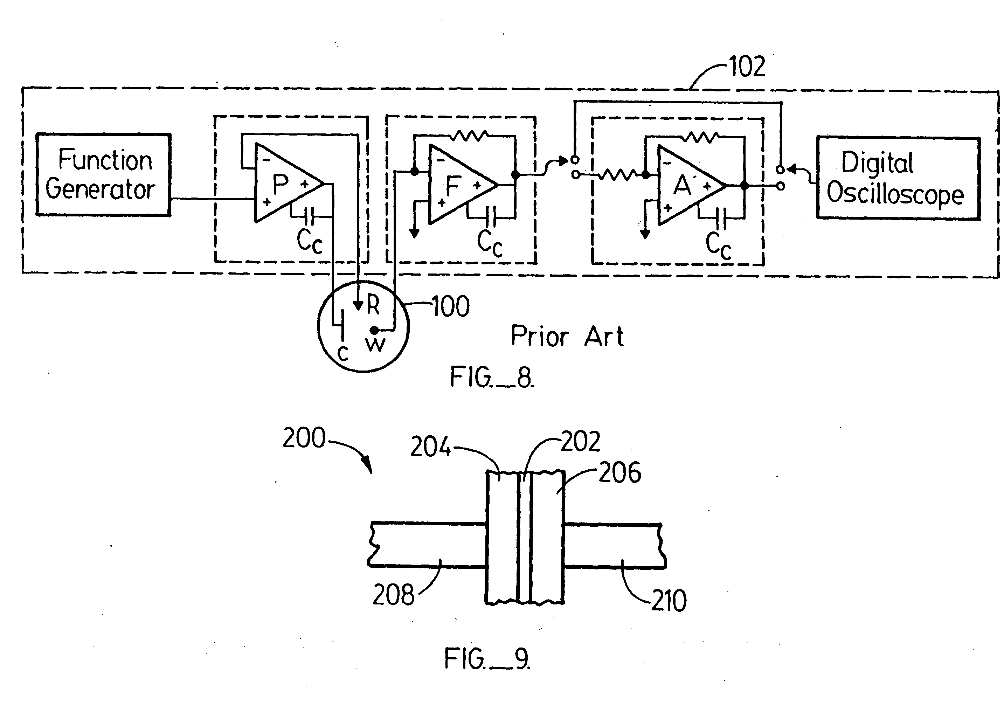

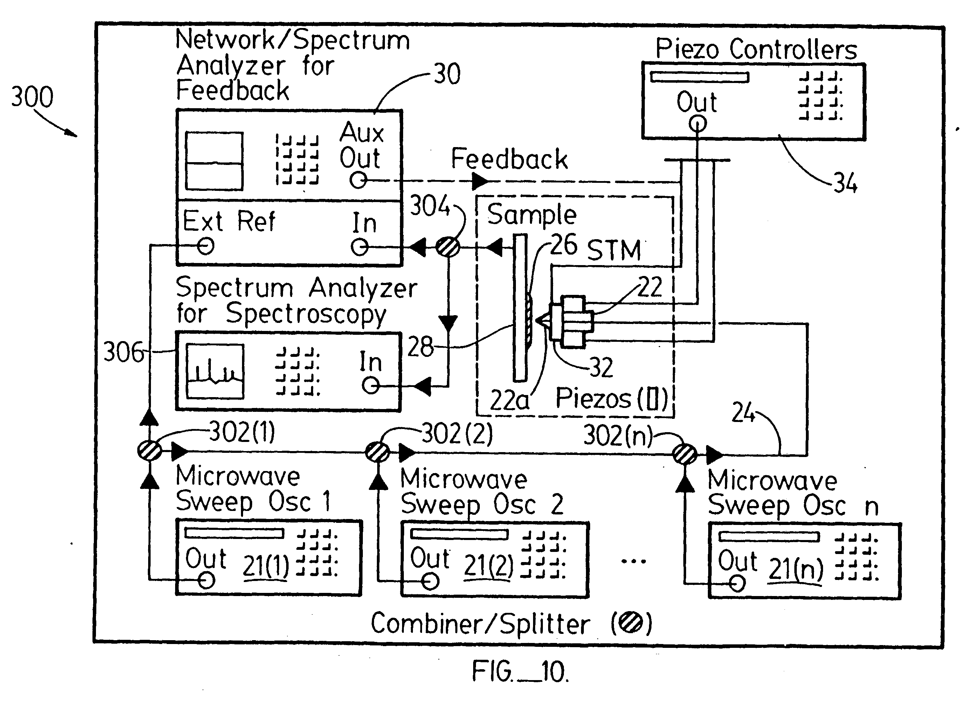

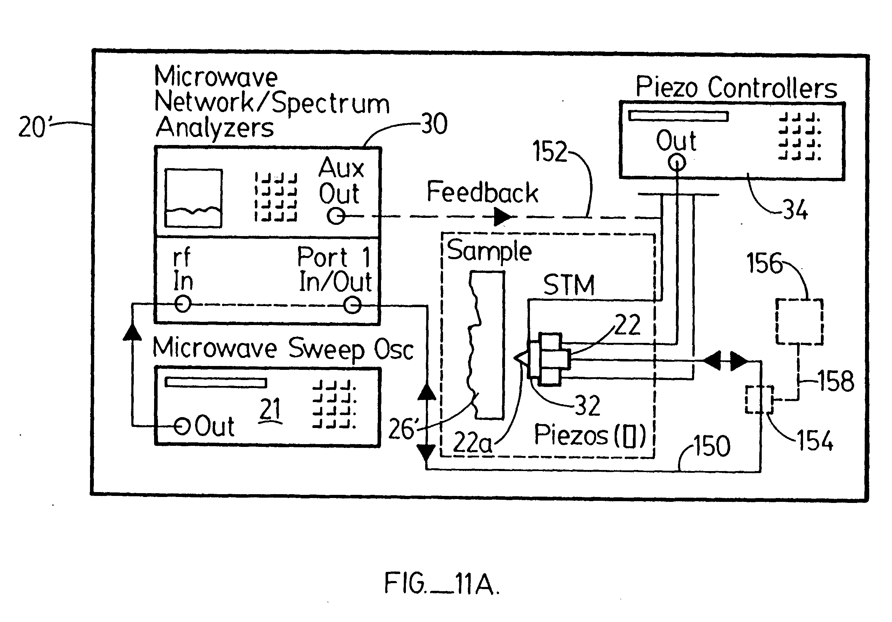

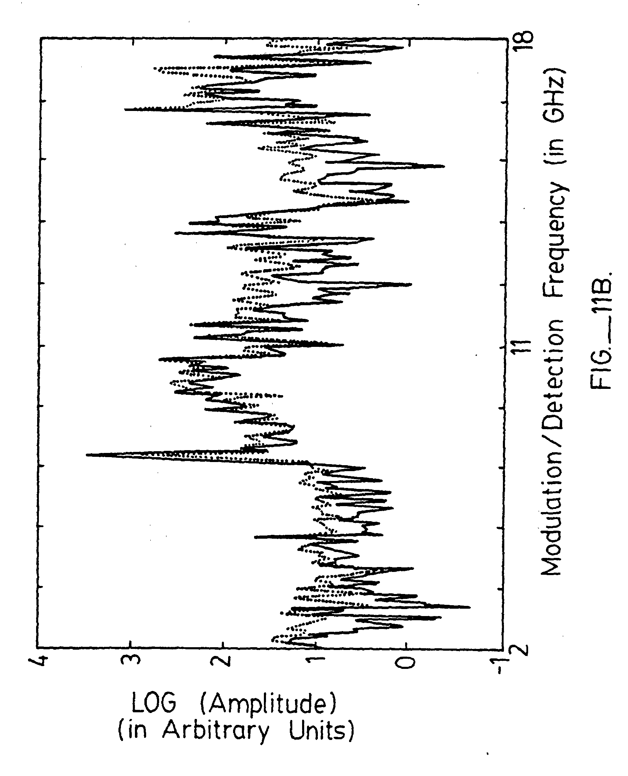

Fig. 11B is a graphical illustration of the ratio of the current or voltage of the reflected signal measured using the scheme of Fig. 9 at the fundamental frequency to the voltage or current applied to the STM electrode at the fundamental frequency. Shown in Fig. 10 also is a graphical illustration of the ratio of the current or voltage of the signal transmitted through the same substance measured using the scheme of Fig. 1 at the fundamental frequency to the voltage or current applied to the STM electrodes at the fundamental frequency to electrodes across a substance, where the reflected and transmitted signals are measured simultaneously.

Fig. 12 is a graphical illustration of an AC signal resulting by combining two signals of two different single frequencies to illustrate the invention.

Figs. 13A, 13B are schematic diagrams illustrating a one-dimensional and a two-dimensional array respectively of Coulomb blockade devices to illustrate the invention.

Fig. 14 is a schematic diagram of a high frequency STM for imaging insulator surfaces using throughput attenuation with a network analyzer, or using non-linear harmonic recording with a spectrum analyzer, and a DC source and detector.

For simplicity in description, identical components in the different figures are referred to in this application by the same numerals.

### Detailed Description of the Preferred Embodiment

Fig. 1 is a schematic diagram of a system 20 including a high frequency scanning tunneling microscope for imaging samples using throughput attenuation with a network analyzer, or using non-linear harmonic recording with a spectrum analyzer to illustrate the preferred embodiment of the invention. As shown in Fig. 1, a microwave sweep oscillator 21 generates an AC signal and applies it to microscope probe 22 with tip 22a (or to the sample 26 through counter electrode 28, not shown in Fig. 1) through line 24. Tip 22a is placed close to but spaced apart (by vacuum, a gas or a fluid) from a sample 26 that is placed on-top of the counter electrode 28. Counter electrode 28 is connected to microwave spectrum/network analyzers 30. The position of the probe tip 22a over sample 26 is controlled by piezoelectric crystal 32, which is in turn controlled by piezo controllers 34. Controllers 34 receive from analyzers 30 a signal to be used for feedback.

In operation, the microwave sweep oscillator 21 applies the AC signal to tip 22a and analyzers 30 applies typically a reference voltage such as a virtual ground to counter electrode 28. The current or voltage between electrodes 22, 28 is monitored by analyzers 30 which derives a feedback signal for controlling controllers 34. In the constant current mode, this feedback signal is applied to the piezo controllers 34 for moving the tip 22a away from or towards the sample 26 in order to maintain a constant signal amplitude between electrodes 22, 28. In constant height mode, the distance between tip 22a and counter electrode 28 is maintained at a constant value and the feedback signal derived from the output of analyzers 30 is either not applied to controllers 34 or attenuated to a very low value before it is applied to controllers 34.

The scheme in reference to Fig. 1 differs from Kochanski's described above in that a tunable source is used to generate the AC signal applied across the electrodes and the amplitudes of the current or voltage can be measured simultaneously at frequencies within a predetermined spectrum using the analyzer. Analyzer 30 then computes the ratio between the amplitudes of the current or voltage measured to the amplitudes of the voltage or current applied by oscillator 21 to probe 22 at frequencies over a predetermined range or spectrum. Where the amplitudes are measured using a network analyzer, both the amplitudes and phases of current or voltage can be measured and used for imaging or spectroscopy.

When a voltage is applied across electrodes 22, 28, depending on the threshold of the substance in sample 26 at the position of the tip 22a and the distance between sample 26 and the tip 22a, electrons may tunnel between tip 22a and the sample. Such tunneling phenomena has been the subject of studies, one of which is set forth in the article "Single Electronics," by Likharev et al., Scientific American, pp. 80-85 (June 1992). As noted by Likharev et al., the application of a voltage across an insulating layer will cause a surface charge Q to build up across the barrier. When an electron tunnels through the insulating layer, the surface charge Q will change exactly by +e or -e, depending on the direction of tunneling, where e is the electrical charge of a single electron. If the charge Q at the junction is greater than +e/2, an electron can tunnel through the junction in a particular direction, subtracting e from Q. The electron will tunnel in the opposite direction if the charge Q is less than -e/2. If Q is less than +e/2 and greater than -e/2, tunneling in any direction would increase the energy of this system. If the initial charge is within this range, tunneling would not occur and this suppression of tunneling is known as Coulomb blockade.

If the surface charge Q falls outside the range for Coulomb blockade so that electron tunnels through the insulating layer, which may cause the surface charge Q to fall within such range again. In such event, further tunneling is not possible. This is caused by the effect of the electric field exerted by the electron which has tunneled through on other electrons which may follow in its path.

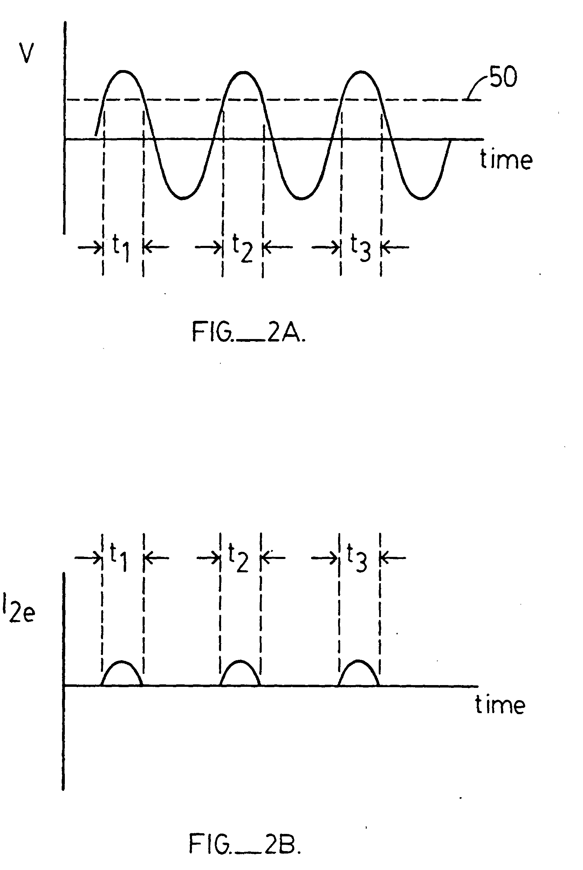

The effect of applying a sinusoidal voltage across two electrodes separated by an insulating layer is shown in Fig. 2A. Thus, when the voltage applied exceeds a certain threshold 50 shown in dotted line in Fig. 2A, this causes the surface charge across the insulating layer to exceed the Coulomb blockade range. Thus, it is only during the time periods t1, t2, t3 that more than one electron can tunnel through the insulating layer in a single cycle to cause the current flow as shown in Fig. 2B.

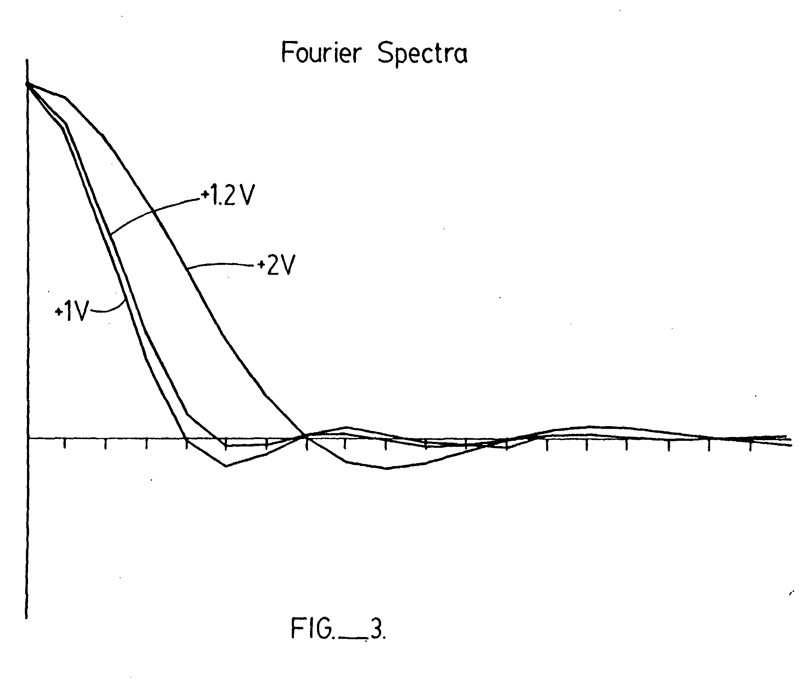

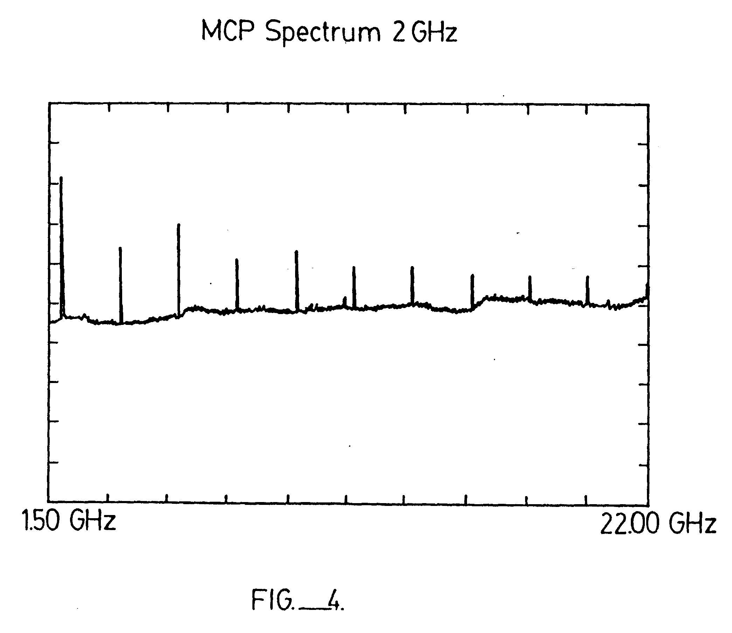

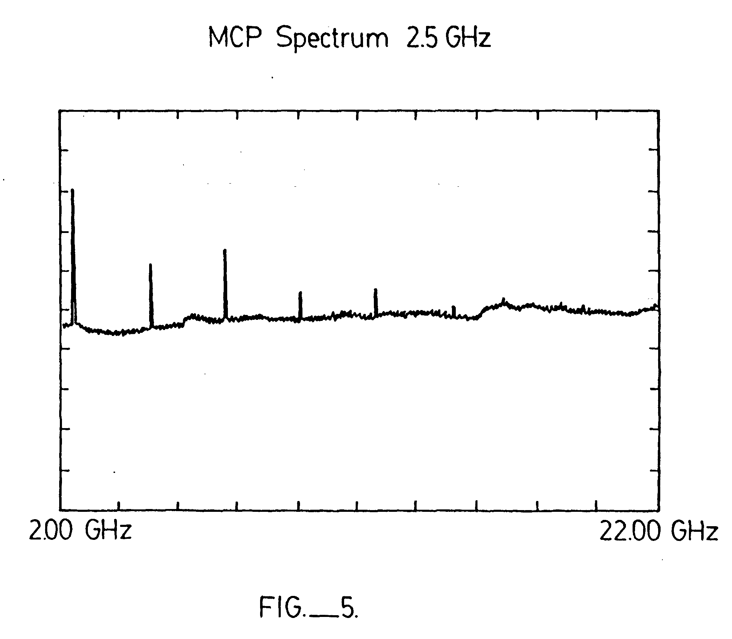

The invention of this application is based on the observation that the threshold voltage of the substance in the sample can be determined by measuring the amplitudes of the current or voltage across electrodes over a predetermined frequency spectrum. Also, by inverse Fourier transform from the frequency domain to the time domain or by measuring directly in the time domain, graphs such as those in Fig. 2B can be obtained for determining the threshold of the substance in the sample. The Fourier spectra of three different substances with respective thresholds of 1 volt, 1 and 2 volts, and 2 volts are illustrated in Fig. 3. Thus, by performing an inverse Fourier transform of the three spectra, the respective thresholds of 1 volt, 1 and 2 volts, and 2 volts can be obtained. In this connection, Fig. 4 is a graphical illustration of a spectrum of a substance when a 2 GHz signal is applied by oscillator 20 across electrodes. Fig. 5 is a graphical illustration similar to that of Fig. 4 except that the oscillator applies an AC signal of 2.5 GHz instead of 2 GHz.

As illustrated in Figs. 2A, 2B, when the amplitude of the AC signal applied across the electrodes is varied, such as where the amplitude is continually increased, one will see a sudden increase in the current flow between the electrodes when a threshold is reached. This will cause a sudden change in current and voltage across the electrodes which can be detected to indicate the presence of a threshold. This may be accomplished by comparing the amplitudes of the high harmonics to those of the low harmonics of the driving frequency of oscillator 21. When the amplitude of the AC signal applied across the electrodes is varied by gradually reducing the amplitude, the surface charge buildup on one side of the insulating barrier caused by the tunneling electrodes would tend to dissipate because of the mutual repulsion of the electrons. The dissipation rate of the electrons will reveal the rates of motion of charges in the substance, and the charge transport characteristics of the substance. When the amplitude of the signal is varied, the frequency of the signal is preferably kept substantially constant.

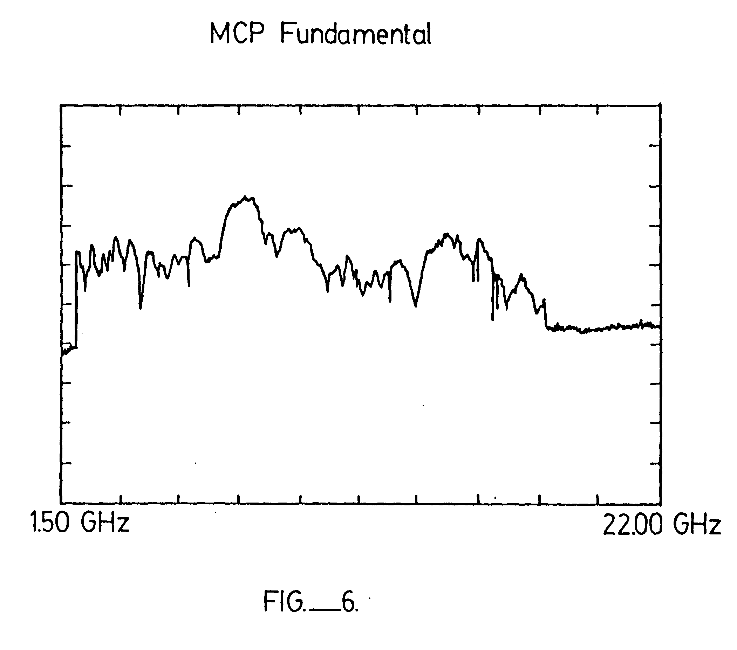

Oscillator 21 may be used to provide different frequency input AC signals across the electrodes. The amplitudes of the current or voltage across the electrodes may be measured as described above to obtain the spectra such as those shown in Figs. 3-5 for different frequency input signals. Preferably, the amplitude of the signal provided in the above procedure remains substantially unchanged when the frequency of the signal provided by oscillator 21 is varied. From the various spectra obtained, an optimum value may be obtained for the frequency of the signal applied by oscillator 21, such as one which maximizes the signal detected. Fig. 6 illustrates such a feature. Fig. 6 shows the frequency response at the fundamental for tip 22a at the same spot of the sample. In other words, Fig. 6 is a plot of the ratio of the amplitude at the fundamental frequency of the current or voltage measured to the amplitude of the voltage or current applied to the electrodes, as the fundamental frequency of the signal applied by oscillator 21 is swept from 1.5 to 22 GHz. In other words, if the frequency response at the fundamental frequency is measured as the frequency of the applied signal sweep, the optimum frequency is indicated by the peak of the curve in Fig. 6 at about 7.7 GHz. -This indicates that when the input signal is at such frequency, the signal recorded is maximum at the fundamental frequency. Obviously, the amplitudes at frequencies other than the fundamental may be used instead and are within the scope of the invention. Fig. 6 is obtained by sweeping the fundamental frequency supplied by the oscillator 21 under control of the analyzer 30, although this frequency can also be swept independently.

Once the optimum frequency is discovered, oscillator 21 may be tuned to such frequency and the STM is used in an otherwise conventional manner in either the constant current or constant height mode for differentiating surface species or for obtaining images of the surfaces of a substance or sample. By selecting particular frequencies which allow contrast between different surface species, the AC STM can be used to generate a map of the chemical species, the chemical environment or physical structure on the surface.

It is important to determine the spectral match (or lack thereof) between measurements of a known species and an unknown. The information may be used to determine the surface composition of one area versus another, or to intercompare an unknown with a previously characterized sample. Samples that can be visually intercompared with known spectra for identification purposes are the simplest case. If the differences are more subtle, a mathematical convolution of the known and unknown to highlight the differences assists the user to see the degree of agreement or lack thereof between the spectra. Where multiple source and detection frequencies are employed in the invention of the present application, such convolution is especially useful since more data would be available for a constrained fit. There are cases where the spectra are qualitatively very similar, or the signal to noise ratio is poor, or it is desired to have a numerically based recognition of match. A statistical intercomparison of the spectra can be used to differentiate an unknown amongst a wide range of candidates. There are many approaches. Amongst them are the least square distance between spectra or a calculation of the eigenvector distance between spectra in n-dimensional space.

Where the amplitudes of the current or voltage are to be measured at a fundamental frequency, a network analyzer is used. Where measurement of amplitudes at different frequencies across an entire spectrum is desired, a spectrum analyzer is used. Other instruments that may be used include lock-in amplifiers, microwave transition analyzers measuring at one frequency and its harmonics, vector voltmeters and power meters with tunable filters.

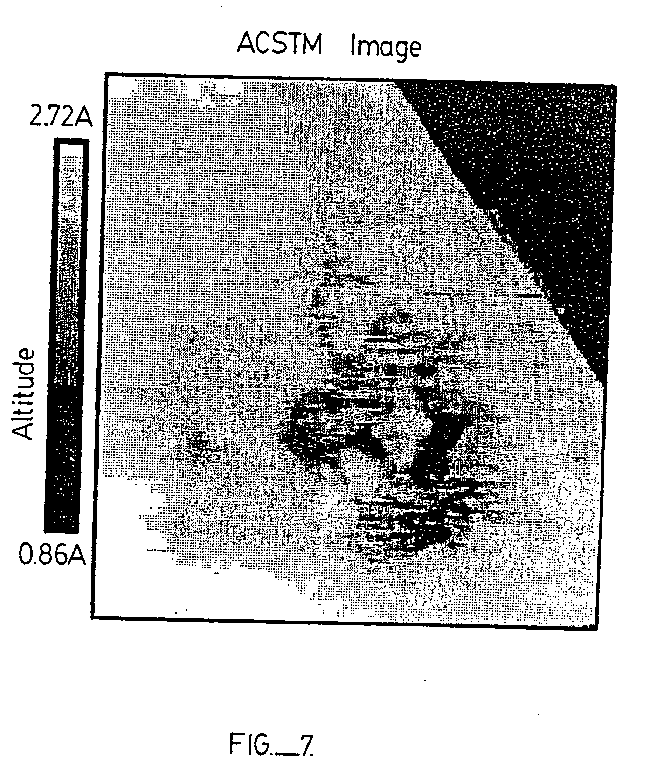

Fig. 7 shows an image obtained of an edge of a pore on the surface using an STM employing the system of the invention of this application. Since the invention functions at the atomic or molecular level, it is possible to detect and measure surface species and other local phenomena.

The concept of this invention can be used not only for application to STM but also to other technologies including Coulomb blockade applications and electrochemical applications.

The invention of this application is particularly useful for detecting fast electrochemistry. This is useful for analyzing electrochemically generated species before they diffuse away from the electrode at which they are generated and/or undergo subsequent reaction. It is also possible to analyze chemical species where the electrochemical environment is rapidly changing, such as in electrochemical probing of living cells. Fast electrochemistry can also be used to determine reaction rates and mechanisms. By using a very high modulation frequency, it is possible to measure extremely small numbers of molecules at very small electrodes by being able to measure a signal from each molecule present repeatedly as a form of signal amplification.

Fig. 8 is a schematic view of an electrochemical cell and a circuit of a potential controlling and current measuring instrument for monitoring the cell in a conventional arrangement taken from "Ultramicroelectrodes: Cyclic Voltammetry Above One Million V s⁻¹," by Andrieux et al., J. Electroanal. Chem., 248:447-450 (1988). As shown in Fig. 8, electrochemical cell 100 is monitored by circuit 102 having counter electrode C, reference electrode R, and working electrode W. The scheme in Fig. 8 can be readily modified so that a concept of the invention may be applied thereto. In reference to Figs. 1 and 8, the working electrode W is connected to analyzers 30 in the same way as counter electrode 28 of Fig. 1. The output of oscillator 21 is applied to counter electrode C and reference electrode is connected to analyzers 30. Then the above-described operation for the STM may be adapted for measuring the fast electrochemistry of cell 100.

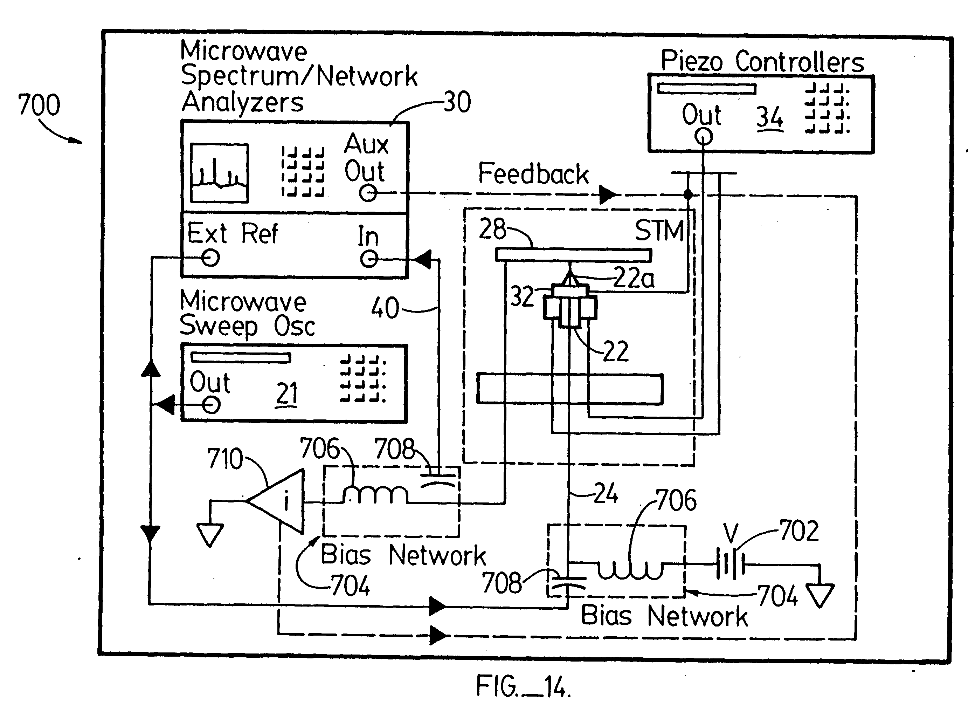

By using a very small working electrode, the capacitance of the bilayer (the molecules aligned at the electrode surface) is reduced, thereby reducing the associated RC time constant of the electrochemical cell 100 in order to increase the speed of the measurement. In reference to Fig. 8, a high frequency AC signal with or without a DC bias is applied to the counter electrode and the frequency spectrum at the current at the working electrode is sensed. The frequency spectrum obtained from such measurements will reflect the current/voltage curves, since the current/voltage characteristics of the electrochemical cell are highly non-linear. Working at high frequency will outrun certain processes such as diffusion of electrochemically generated species away from the electrode. The DC bias can also be set to a feature of interest in the current/voltage characteristic of the electrochemical cell. Then by varying the modulation frequency, the rate of the electrochemical process can be monitored. As described in more detail below in reference to Fig. 14 of this application, in addition to an AC signal source, a source for applying a DC bias voltage and current is also included so that the AC signal from the oscillator 21 is superposed onto such DC signal before the summed time varying signal is applied to the cell 100.

Fig. 9 is a schematic view of a Coulomb blockade device 200 sandwiched between two conductive layers 204, 206 connected respectively to electrodes 208, 210. Again the dotted line box in Fig. 1 is replaced by the Coulomb blockade device 200 of Fig. 9 so that the general scheme of Fig. 1 may be used for monitoring the Coulomb blockade device 200. More specifically, electrode 208 may be connected to the network analyzers 30 through conductor 40 and electrode 210 may be connected to oscillator 21 through conductor 24. The scheme of Fig. 1 can then be used for measuring thresholds and charge dissipation rates in a manner similar to that described above for the STM. The thresholds are measured by varying the amplitude of the applied AC signal. When the amplitude is increased and a threshold is reached, only the peak of the sine wave will be at sufficient amplitude to transfer a second, third ... electron across the insulating barrier 202. Thus, there will be a signal that is a fairly sharp feature in time. Short time features such as these correspond to high frequencies. An increase in the higher harmonics as this threshold is surpassed is expected. As the amplitude is further increased, the time period over which the sine wave amplitude is over the threshold is increased. This gives a more slowly varying signal, so that the amplitude of the higher harmonics decreases relative to the lower harmonics. If the amplitude of the current or voltage across the electrodes 208, 210 are monitored at frequencies within a spectrum, the spectra obtained may be transformed using Fourier transform to obtain the threshold. Alternatively, if simply an indication of the threshold is needed, the sudden change in current or voltage across the electrodes 208, 210 will be adequate.

To measure the charge dissipation rates across device 200, after the thresholds are known, the modulation frequency is varied with the amplitude held constant. If charge escapes during a period, then the threshold (which is due to repulsion from the previous tunneled charge) disappears as does the corresponding non-linearity. The higher harmonics would then decrease as the signature that the dissipation is taking place on the time scale of the modulation. Again, by comparing the amplitudes of the high harmonics to those of the low harmonics of the driving frequency, such dissipation can be detected. This is the case also when a sample or an electrochemical cell is measured using a STM. By applying a summed signal having both AC and DC components in the manner described below in reference to Fig. 14, it is possible to maintain a DC bias at a certain level that would match or approach the threshold concerned while varying the modulation frequency or amplitude.

Since different molecules or particles will exhibit different spectra, it is possible to record the atomic or molecular spectra of a known substance to be a signature for comparison with atomic or molecular spectra of an unknown substance detected using the scheme above. The comparison will yield useful information on the composition of the unknown substance.

Further aspects of this invention will be explained below in reference to Figs. 10-12. As described above, for a given substance in the sample, an optimum value may be obtained for the frequency of the signal applied by oscillator 21, such as one which maximizes the signal detected as illustrated in Fig. 6. Such optimum frequency is a characteristic of the substance. Generally speaking, two different substances will have two different optimum frequencies neither of which is an integral multiple of the other; in other words, the optimum frequency of each of the two substances is not a harmonic of the optimum frequency of the other substance.

In reference to Fig. 1, when sample 26 includes two different substances, two different optimal frequencies will be discovered using the apparatus of Fig. 1 as the fundamental frequency of the signal applied by oscillator 21 is swept. In such circumstances, one would have to choose one of the two optimal frequencies to maximize the signal recorded since oscillator 21 can only be tuned to one of the two optimal frequencies. Therefore, to obtain maximum recorded signals for the two substances, one would normally have to first tune oscillator 21 to one optimal frequency during a first run for measuring a first substance, and tune the oscillator to a second optimal frequency to measure a second substance during a subsequent second run. If the two substances are present simultaneously only for a short time period, measuring the two substances sequentially as described may not be feasible. It is therefore desirable to provide a system whereby two or more substances may be detected simultaneously and at optimal frequencies.

Where two different substances close together are measured over a spectrum as the input frequency is swept, the above described scheme may need to be modified. Instead of finding a single optimal frequency for both substances, to differentiate between the responses of the two substances, one would attempt to find a first optimal frequency where the response of a first substance is measurably higher than that of a second substance, and a second optimal frequency where the response of the second substance is measurably higher than that of the first substance. This may be possible even though at many other frequencies other than the first and second frequencies, the responses of the two substances are nearly the same. In such event, it would be useful to identify each of the substances by more than one frequency as its characteristic frequencies. Therefore, to obtain optimized results, one would supply to the ACSTM an input signal having components at each of the optimal frequencies.

Fig. 10 is a schematic view of a high frequency STM for imaging substances using a network or spectrum analyzer and multiple oscillators to illustrate the invention of this application. For convenience and description, identical components are labeled by the same numerals in all the figures of this application. The scheme 300 in Fig. 10 differs from that of Fig. 1 in that n microwave sweep oscillators 21(1), 21(2), ..., 21(n) are used to supply signals of multiple frequencies instead of only one oscillator 21 supplying signals of a single frequency input. The output of oscillator 21(1) is applied to a combiner 302(1) where the output is split into two paths: one path towards combiner 302(2) and the other to the external reference port of the network/spectrum analyzer 30. Combiner 302(2) combines the outputs of oscillators 21(1), 21(2) and sends the combined signal to combiner 302(3) (not shown) which combines such combined signal with the output of oscillator 21(3) (not shown) and so on until combiner 302(n) combines the output of oscillator 21(n) with the outputs of the remaining (n-1) oscillators, and sends the combined signal from the n oscillators along line 24 to the STM probe 22. The combined signal from line 24 is applied to tip 22a and a current or voltage between electrodes 22, 28 is monitored by analyzer 30 or analyzer 306 in a manner described above. Instead of applying the signal to the probe 22, it is possible to apply it instead to the counter electrode and thus to the sample; the response of the sample is then detected using the probe. As described below in reference to Fig. 14, a DC voltage or current source may be used in addition to supply a DC bias voltage and current upon which the AC combined signal from the outputs of the oscillators are superposed and the combined or summed time varying signal including DC and AC components supplied to probe 22 or counter electrode through line 24. Such source has been omitted from Fig. 10 for simplicity, it being understood that such optional source is intended and is very useful for electrochemical and Coulomb blockade device applications as explained below. Alternatively, instead of using a number of oscillators and a DC source, it is also possible to use a source generating signal pulses or transients. In general, one can use a source that generates a DC signal, an AC signal, a signal pulse or a signal transient or a combination of two or more thereof; all such variations are within the scope of the invention.

A combiner that may be used is a combiner/splitter, although other devices that combine signals may be used as well and are within the scope of the invention. While the embodiments may be described in terms of combining signals and applying the combined signal to the ACSTM, it will be understood that mixers (not shown) may be used to mix the input signals instead and the mixed signal applied to the ACSTM and the invention as described herein will function in essentially the same way to provide all the advantages described herein. In such case, each of the combiners 302(1), 302(2), ..., 302(n) would be replaced by a mixer instead.

If analyzer 30 is generating a feedback signal to controllers 34, then a separate spectrum analyzer 306 is needed to detect and record the detected signal spectrum while analyzer 30 is generating the feedback control signal. For this purpose, combiner or signal splitter 304 sends the current or voltage signal from the counter electrode 28 to analyzers 30 and 306.

Each of the frequencies of the outputs of the n oscillators can be chosen to isolate or to indicate particular features such as the use of spectral signatures or functional groups of molecules of interest. Each frequency or a combination of frequencies can be used to probe a particular chemical or physical aspect of the sample. In the context of this application, a combination of frequencies is defined as integral multiples (harmonics) of each of the frequencies, and/or sums or differences of such frequencies or multiples. Each of the frequencies from the oscillators and combinations thereof may be detected simultaneously using the spectrum/network analyzer 306. It is therefore possible to map the regions of surfaces containing particular chemical species or exhibiting particular phenomena (e.g., electrical charging).

Since the signal applied to probe 22 has a number of different input frequencies, the voltage or current signal detected from the counter electrode 28 and fed to analyzer 306 also has such frequencies and/or combinations thereof. One of these frequencies may be used for feedback purposes to control piezo controllers 34 and in order to control the height of probe 22 above counter 28. This may be accomplished by moving the probe tip or by moving the counter electrode and the sample. Thus, the detected signal from counter electrode 28 is split by combiner 304 into two paths, one to analyzer 30 and the other to spectrum analyzer 306 for spectroscopy. Analyzer 30 then uses one of the frequencies in the current or voltage from counter 28 to derive an error signal in a feedback path 310 to controllers 34 for controlling the height of probe 22 to reduce such error signal. For this purpose, the controllers 34 may control either the position of the probe tip 22a as shown in Fig. 10, or the position of the counter electrode 28 and the sample (not shown). It will be understood that manners of control other than those discussed above may also be used, such as a DC voltage from an optional DC source (not shown in Fig. 10). When an AC or DC feedback is employed to derive an error signal, such feedback action would tend to reduce the error signal so as to maintain a constant current flow between tip 22 and counter electrode 28. Alternatively, the feedback voltage may be turned to a very low value or not applied at all to controllers 34 in a "constant height mode."

Another aspect of the invention of this application will now be described by reference to Figs. 11B, 11B below as well as the description above. Fig. 11A is a schematic diagram of a high frequency AC STM for imaging bulk insulator surfaces by measuring the reflected signal using the network analyzer, or using non-linear harmonic recording with a spectrum analyzer. As shown in Fig. 11A, where the sample to be measured is a bulk insulator, such as a salt crystal or mineral or a living cell of an organism, it may not be possible to measure the tunneling current or voltage in the manner described above. In such circumstances, the apparatus 20' of Fig. 11A will enable such substance to -be measured.

In the same manner as described above, the sweep oscillator 21 supplies an AC signal to analyzer 30 which in turn supplies a microwave signal to sample 26' through tip 22a of the STM. This signal is transmitted from analyzer 30 to the STM through cable 150. Instead of detecting the tunneling signal transmitted from tip 22a to sample 26', which is not possible for a bulk insulator, the signal transmitted by tip 22a and reflected by sample 26' is detected instead at tip 22a, where such reflected signal is transmitted by cable 150 back to analyzer 30 at input/output port 1. Analyzer 30 records the reflected signal received at port 1. As indicated above, analyzer 30 is capable of recording the amplitude at one frequency or amplitudes at different frequencies over a predetermined spectrum of signals and therefore records the amplitudes at different frequencies within a predetermined spectrum of the reflected signal from cable 150.

Fig. 11B is a graphical illustration of the ratio of the current or voltage of the reflected signal measured using the scheme of Fig. 11A at the fundamental frequency to the input voltage or current applied to the STM electrode at the fundamental frequency. Analyzer 30 is of the type which can record both the reflected signal and the transmitted signal where the transmitted signal is recorded in the manner described above in reference to Fig. 1. Thus where both the transmitted and reflected signals are detected, as where the substance is thin or small or conductive, the transmitted signal may be detected by another electrode (not shown in Fig. 11A but similar to electrode 28 of Fig. 1) and sent to analyzer 30 to a port (not shown in Fig. 11A) different from port 1. Shown also in Fig. 11B is a graphical illustration of the ratio of the current or voltage of the signal transmitted through the same substance as in Fig. 11A, measured using the scheme of Fig. 1 at the fundamental frequency to the voltage or current applied to the STM electrodes at the fundamental frequency to electrodes across a substance where the reflected and transmitted signals are measured simultaneously. in Fig. 11B, the reflected signal is plotted in solid lines whereas the transmitted signal is plotted in dotted lines. Thus, both the transmitted and reflected signals are measured when tip 22a of the STM is close to a sample 26'. This assumes that the sample 26' is not a bulk insulator so that the transmitted signal at electrode 28 of Fig. 1 can also be detected and measured and sent to analyzer 30.

As demonstrated in Fig. 11B, it appears that the spectrum of sample 26' obtained by detecting the reflected signal is similar to the spectrum obtained by detecting the transmitted signal caused when electrons tunnel through sample 26'. This demonstrates that, when electrons are transmitted by tip 22a towards sample 26', the signal reflected by the sample 26' back towards tip 22a has similar signal characteristics as the signal that is transmitted through the sample 26'. Hence, all of the above-described applications possible by detecting the transmitted signal caused by tunneling electrons are also possible where the reflected signal is detected instead of the transmitted signal. In addition, the reflected signal may be fed back through path 152 from analyzer 30 to controller 34 for controlling the distance between tip 22a and sample 26' in a constant current mode. Where such feedback path is turned off or severely attenuated, the STM is operating in constant height mode. This also demonstrates that where only one electrode is used to couple the signal to the sample or substance measured, measuring the reflected signal instead of the current through or voltage across the sample or substance is possible even though the sample or substance is electrically conducting.

Where the analyzer 30 used is not suitable for detecting the reflected signal from cable 150 also used to transmit the input signal to the sample, a directional coupler 154 shown in dotted lines in Fig. 11A may be used to separate the reflected signal from the input signal from oscillator 21 on cable 150, and this reflected signal is sent to an appropriate device 156 also shown in dotted lines in Fig. 11A through line 158. Device 156 then detects and measures the reflected signal. Device 156 may be a spectrum analyzer, a network analyzer, a vector voltmeter, a power meter used with tunable filters, or any other device capable of measuring amplitude versus frequency.

Where the scheme of Fig. 11A is used for detecting electrochemical changes, the configuration of Fig. 8 needs to be modified only in the sense that the reflected signals detected from the working electrode W are measured instead of the transmitted signal from electrode C. Reference electrodes R may still be used for the electrochemical cell in this context. The reflected signal detected from the working electrode W may then be used in the same manner as that described above for the transmitted signal, for measuring various characteristics of the electrochemical change.

By combining or mixing electrical signals of different frequencies, the embodiment of Fig. 10 enables sums and differences or other combinations of the n frequencies to be generated and applied to the sample 26. This is advantageous for a number of reasons as described below.

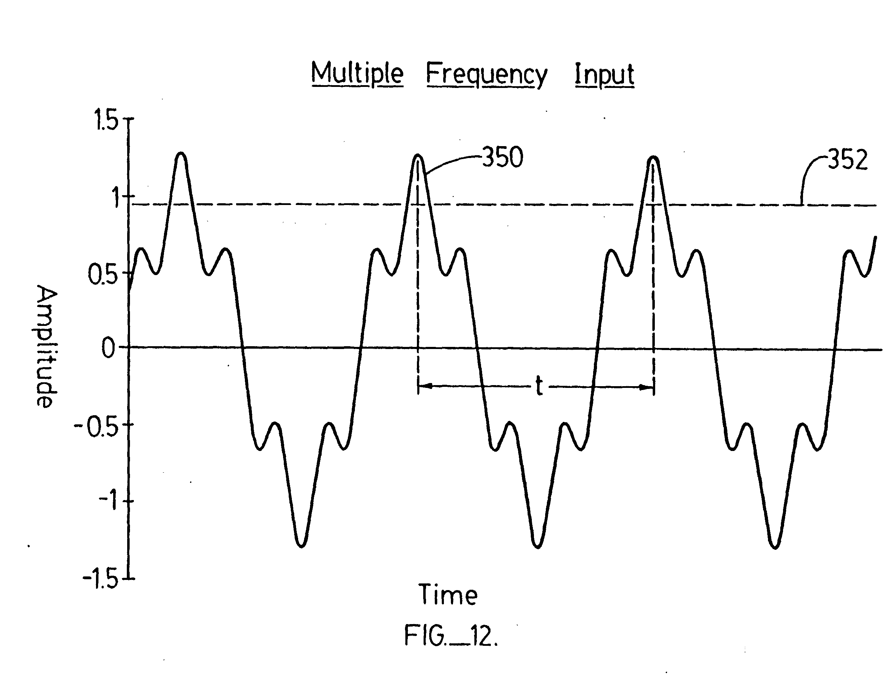

The signal output resulting from combining two sine wave signals of different frequencies is illustrated in Fig. 12. As shown in Fig. 12, by combining two signals of different amplitudes, one would obtain sharp spikes 350 of amplitudes greater than the amplitudes of the two sine wave signals from the oscillators, the sine wave signals being combined to obtain the wave form of Fig. 12. The sharp spikes 350 are of a shape determined by the sum of the frequencies of the two input sine waves, where the sharp spikes 350 would occur at a frequency equal to the difference between the two input sine wave forms. In Fig. 12, the period of such spikes 350 is t, which is greater than the periods of either one of the two input sine wave forms. The duty cycle of the spikes is 1/t.

Where Fig. 12 is a graphical illustration of a voltage wave form of the signal resulting from combining input voltage signals of two different frequencies, the wave form obtained has a higher amplitude than the two input voltage signals. It is evident that spikes 350 exceed the threshold 352 only for short periods of time at a duty cycle 1/t. If the voltage wave form of Fig. 12 is generated by combining two voltage wave forms having frequencies f1, f2, then the duty cycle 1/t is given by the difference frequency f1-f2 of the two input frequencies. The shape of the spikes 350 is determined by the sum f1+f2 of the two input frequencies. Therefore, by choosing the proper input frequencies f1, f2, it is possible to control the shape of the spikes 350 as well as the duty cycle of the spikes. Instead of combining the input signals as illustrated in Fig. 12, it is also possible to mix the input signals and apply the mixed signal instead to form wave forms of the desired shape and duty cycle. Where the voltage wave form of the signal applied to the probe tip 22a of the ACSTM or sample 26 results from combining or mixing more than two signals of different frequencies, it is possible to further fine tune the shape and duty cycle of the spikes. By combining or mixing input signals of two frequencies and applying the combined or mixed signal to the ACSTM, the response of the substance(s) may be measured at the difference frequency instead of at higher frequencies. This may be advantageous if measurement at such low frequency has a better signal to noise ratio than at certain higher frequencies.

The scheme of Fig. 10 may be advantageous for applications in electrochemistry, such as when applied to the electrochemical cell of Fig. 8, or simply where sample 26 in Fig. 10 is undergoing electrochemical changes, such as in a living cell. By using multiple source and detection frequencies, it is possible to analyze and to separate the effects of more than one electrochemically generated species prior to diffusion away from the electrode at which they are generated and/or subsequent reaction. It is also possible to analyze simultaneously multiple chemical species where the electrochemical environment is rapidly changing, such as in electrochemical probing of living cells. It is also possible to determine "fast" reaction rate and mechanisms. The separation/speciation of the multiple components in each case could be done on the basis of: (1) the diffusion rate to and from the electrode, (2) the generation or reaction rate adds on near the electrode, and (3) the generation or reaction potential. This is explained in more detail below.

As discussed above in reference to Fig. 12, by combining two sine wave signals of different frequencies and amplitudes, one would obtain sharp spikes 350 of amplitudes greater than the amplitudes of the two sine wave signals from the oscillators, where the sharp spikes 350 are of a shape determined by the sum of the frequencies of the two input sine waves, where the sharp spikes 350 would occur at a frequency equal to the difference between the two input sine wave forms. Such multiple frequency waveforms as shown in Fig. 12 will be useful in electrochemistry. Thus, if sharp spikes 350 obtained from combining two frequencies from two oscillators from 21(1)-21(n) are at an amplitude that exceeds certain generation or reaction potentials, certain species A would cause to be generated at the electrodes by such voltage spikes. Such species A then reacts with another species B to give rise to another species C. If all of the species B near the electrodes have been consumed by the reaction, such reaction cannot continue until species B has time to diffuse to the vicinity of the electrodes again. In such event, the input frequencies of the two oscillators from 21(1) - 21(n) may be controlled so as to give rise to a long enough period t (relaxation time), to allow adequate time for a species B to diffuse to the vicinity of the electrodes. Then another sharp spike 350 would occur, causing the species A generated to again react with species B to generate species C. In order to provide a detectable signal, the different species must be detected repeatedly at the difference frequency between the two input sine wave frequencies to yield a detectable signal at the analyzer 306. In other words, an electrochemical signal due to this event would appear at the difference frequency, such as f1-f2 or its harmonics, where f1, f2 are input frequencies at two of the oscillators 21(1) - 21(n).

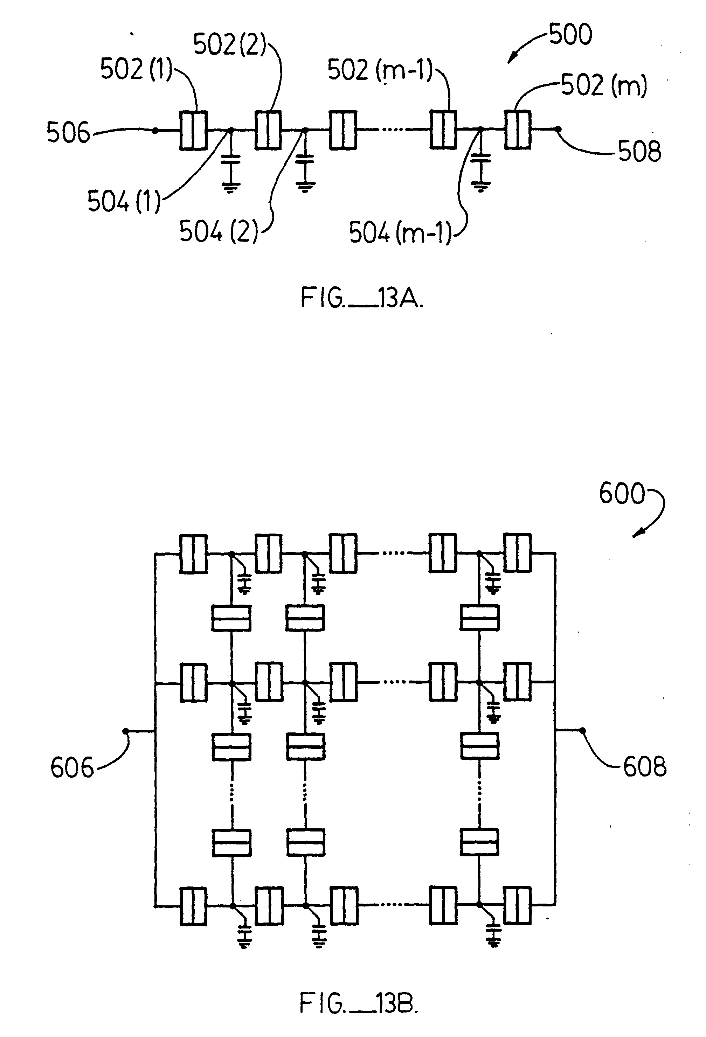

Figs. 13A, 13B are schematic views of a one-dimensional array and a two-dimensional array respectively of Coulomb blockade devices that are currently used. Figs. 13A, 13B are taken from "Single Charge Tunneling Coulomb Blockade Phenomena in Nanostructures," edited by Hermann Grabert and Michel H. Devoret, NATO ASI Series, Series B: Physics, Vol. 294, Chap. 1, page 17, Fig. 9. As described in the above-referenced book edited by Grabert and Devoret, when the appropriate AC voltages with frequency f are applied to the gates (i.e., to the nodes 504(1), 504(2), ..., 504(m-1)) in Fig. 13A, between adjacent blockade devices 502(1), 502(2), ..., 502(m), the current flowing between input 506 and output 508 is proportional to the frequency f. Therefore, by controlling the frequency applied, it is possible to generate precise currents. This is the basis of high precision single charged tunneling current sources. See Devoret and Grabert, page 16, lines 1-7.

For the array 500 to act as an effective current standard, it is desirable for the devices 502(1)-502(m), collectively referred to as devices 502, to have the same resonance frequency. If the devices 502 have somewhat different resonance frequencies, this will cause array 500 used as a current standard to be inaccurate. To detect whether the Coulomb blockade devices have the same resonance frequencies, an input signal including components at two frequencies which are different by a small offset may be applied to the input 506 and the current or voltage at 508 is measured at said at least two frequencies or their harmonics, or various combinations thereof to indicate the accuracy of the standard. In other words, if current standard 500 responds to such input signal by causing a current or voltage at output 508 to include both frequencies or their harmonics, or various confirmations thereof, it tends to indicate that the devices have different resonance frequencies. The apparatus of Fig. 10 may be applied to the current standard 500 by replacing the dotted line box in Fig. 10 by the array 500 so that line 24 is connected to the input 506 and the output 508 of the apparatus 500 is connected to splitter 304.

The above-described adaptation of Fig. 10 connected to array 500 may also be used to detect thresholds of the devices 502 and their charge dissipation characteristics. This can be performed by applying a voltage input signal having the wave form shown in Fig. 12 to the input 506 of the array 500. The voltage wave form of Fig. 12 is obtained again by combining two input voltage wave forms, with frequencies f1, f2 respectively. The respective amplitudes of the two input voltages are varied so that the amplitude of spikes 350 is increased to exceed a predicted threshold 352 of one of the Coulomb blockade devices in the array 500. As discussed above, threshold 352 is indicated by the detection of an increase of higher harmonics and their combinations in the spectra. Thus, threshold 352 of the device would be predicted or indicated by presence of large amplitudes of the higher harmonics of the difference frequency f1-f2 or their combinations in the current or voltage detected by the ACSTM.

The charge dissipation characteristics of the Coulomb blockade devices in the array may be detected as follows. If the frequency f1 is higher than the frequency f2, then the oscillator that generates the voltage signal at frequency f1 is tuned to reduce the frequency f1, while maintaining the same amplitude. If spikes 350 are indeed just above threshold 352, and if the time period during which the spikes exceed threshold 352 becomes comparable to the time scale of dissipation of the devices, this tuning has the effect of broadening the spikes 350 (by reducing f1+f2), thereby increasing their widths, and reducing the difference frequency f1-f2. This prolongs the time during which the total input voltage wave form shown in Fig. 12 exceeds the threshold 352 of the particular Coulomb blockade device, and causes the amplitudes of the higher harmonics of the difference frequency f1-f2 and their combinations to decrease relative to the amplitudes of the lower harmonics of the difference frequency and their combinations. Comparison of the amplitudes of the 'higher and lower harmonics of the difference frequency as the higher frequency of the frequencies of the two sine waves combined is reduced would indicate -the time scale of charge dissipation of the Coulomb blockade devices. In general, it is possible to achieve the same result (that is, changing the width of spikes 350 and the difference frequency) by varying either one or both frequencies f1, f2 or more than two frequencies in order to vary the sum and difference frequencies. Such and other variations are within the scope of the invention.

While the invention as applied to array 500 is illustrated above by example to an array 500 where the blockade devices are arranged in series, it will be understood that the invention is similarly applicable where the devides are arranged in parallel instead or an array with a combination of series and parallel connected devices. The above described schemes for detecting inaccuracies in array 500 used as a current standard or threshold detection in array 500 may also be applied to the two-dimensional array 600 with input 606 and output 608 in the manner similar to that described above for array 500, where line 24 of Fig. 10 is connected to input 606 and output 608 of array 600 connected to splitter 304 in Fig. 10, replacing the dotted line box in Fig. 10.

Fig. 14 is a schematic diagram of a high frequency STM for imaging insulator or conductive surfaces using throughput attenuation with a network analyzer, or using non-linear harmonic recording with a spectrum analyzer, and a DC source and a DC detector. From a comparison of Figs. 1 and 14, it will be evident that, in addition to the components present in Fig. 1, device 700 also includes a DC source 702. The DC voltage from source 702 is coupled together with the AC signal from the sweep oscillator 21 through a bias network 704 to line 24 connected to the tip 22a of the STM. Bias network 704 includes an inductor 706 for coupling a DC voltage or low frequency signal to line 24. The high frequency signal from oscillator 21 is coupled to line 24 through a capacitor 708 in the bias network. In this manner, bias network 704 adds the DC bias voltage or a low frequency signal from source 702 to the high frequency signal from the sweep oscillator 21 and supply the summed signal having both DC and AC components to line 24.

To detect the current that passes between tip 22a of the STM and counter electrode 28 through the sample (not shown), the signal from counter electrode 28 is fed through another bias network 704 which separates the DC or low frequency components from the high frequency components which are supplied through capacitor 708 to line 40 which is connected to a spectrum or analyzer 30. The DC or low frequency components of the current from counter electrode 28 are coupled through an inductor 706 to a current amplifier 710 to detect the DC or low frequency current. The current detected by amplifier 710 may be fed back to piezo controllers 34 in the constant current mode in lieu of or in addition to the AC signal detected as described above. Instead of using oscillators and a DC source as described above in reference to Fig. 14, it is also possible to employ a source generating a signal pulse or a signal transient. In general, one can use a source that generates a DC signal, an AC signal, a signal pulse or a signal transient or a combination of two or more thereof; all such variations are within the scope of the invention.

If instead of using a voltage source 702 to supply a DC voltage and current, a DC or low frequency current source is used instead, device 700 is modified simply by replacing the voltage source 702 by a low frequency or DC current source and the current amplifier 710 is replaced by a voltmeter for detecting the DC or low frequency voltage across the sample. Aside from such change, device 700 will function in essentially the same manner as that described above. Instead of applying the summed signal having both AC and DC components to tip 22a of the STM as described above, such signal may instead be applied to the sample through counter electrode 28; in such event, the current through a sample is then detected at tip 22a of the STM so that the tip is then connected to analyzer 30 and detector 710 through the bias network 704 instead. Such and other possible variations are all within the scope of the invention.

While the invention is described above in reference to various embodiments, it will be understood that various changes and modifications may be made without departing from the scope of the invention which is to be limited only by the appended claims. For example, while the embodiments are illustrated showing a gap between the tip of the STM and the sample, this is not required and the invention may function essentially as described even though the tip contacts the sample. Similarly, while the preferred embodiments above may be illustrated by reference to sources for providing or to devices for detecting AC signals to measure a sample or substance, it will be understood that said sources may provide and said detection devices may detect a DC signal, an AC signal, a signal pulse, a signal transient, or a combination of two or more thereof, the term signal herein referring to a current and/or a voltage, for measuring the sample or substance and the various features of the invention described above are similarly applicable.

## Claims

1. A detection apparatus (20) for detecting a change in amplitude of a current or voltage transmitted through, or reflected from, a substance (26), said change being related to threshold phenomena associated with the substance and/or atomic or molecular spectra of the substance, the apparatus comprising:
a source (21) for providing a time varying electrical signal;
at least one electrode (22, 22a) for coupling said signal to a substance; and
a device (30) connected to the at least one electrode for measuring the amplitude of the current or voltage of an electrical signal at the at least one electrode;
said apparatus **characterised in that** the electrical signal provided by the source has at least one frequency in the range of about 1 to 30 GHz, and **in that** the device measures amplitude changes of the current or voltage of the electrical signal at the at least one electrode substantially simultaneously at two or more frequencies in a predetermined spectrum of frequencies.

2. The detection apparatus of claim 1 **characterised in that** the electrode detects a reflected electrical signal from the substance in response to said time varying electrical signal and **in that** the device measures amplitude changes of the current or voltage of the reflected electrical signal.

3. The apparatus of claim 2, said measuring device measuring the amplitudes of the reflected signal from the electrode over a predetermined spectrum of frequencies.

4. The apparatus of claim 3, said measuring device measuring substantially simultaneously frequencies of the reflected signal over said predetermined spectrum.

5. The apparatus of claim 1 wherein said source is a tunable source for providing said time varying electrical signal at a selected frequency; and wherein said electrode is spaced apart from the substance by a gap, said electrode coupling the time varying electrical signal to the substance across the gap and detecting across said gap a reflected electrical signal from the substance in response to said input signal.

6. The apparatus of claims 1 to 2, said source being tunable to any desired frequency within a predetermined range.

7. The apparatus of claim 1 to 2, wherein said substance is undergoing electrochemical changes.

8. The apparatus of claims 1 or 2, wherein said source is tunable to provide a signal at different frequencies but of substantially the same amplitude.

9. The apparatus of claim 1 or 2 wherein said source comprises:
a tunable source for providing said time varying electrical signal at a selected frequency.

10. The apparatus of any preceding claim wherein said measuring device is a spectrum analyser, a network analyser, a lock-in amplifier, a microwave transition analyser measuring at one frequency and its harmonics, a vector voltmeter, or a power meter with tunable filters.

11. The apparatus of claims 1 or 2, said electrode having a tip (22a) spaced apart by vacuum, a gas or fluid from the substance.

12. The apparatus of claims 11, said apparatus further comprising:
feedback means (152) for deriving an error signal from the current or voltage or of reflected signal measured by the measuring device and the signal provided by the source; and
means (34) for moving the tip to change the distance between the tip and the substance in response to the error signal in order to reduce the error signal.

13. The apparatus of claims 1 or 2, further comprising means for storing amplitude changes corresponding to atomic or molecular spectra of a known substance for comparison with amplitude changes corresponding to atoric or molecalar spectra of an unknown substance detected by the measuring device to detect the unknown substance.

14. The apparatus of claim 13, wherein said electrode and said measuring device are components of a scanning tunneling microscope adapted for scanning the substance to obtain an image of the substance,

15. The apparatus of claims 1 or 2, wherein said source provides a DC signal, an AC signal, a signal pulse, a signal transient, or a combination of two or more thereof.

16. The apparatus of claims 1 or 2, wherein said substance is undergoing electrochemical changes, said apparatus further comprising an electrochemical cell (100) containing the substance, a reference electrode, and wherein said electrode is the working electrode of the cell, so that the amplitude changes of the current or voltage across the working electrode and a reference electrode of the cell or the amplitude changes of the reflected signal from the working electrode, measured over said spectrum, reveal dynamic information concerning the changes.

17. The apparatus of claim 1, wherein said substance is an insulator layer, further comprising a second electrode for coupling the signal to the substance, and wherein the pair of electrodes are attached to the layer to form a Coulomb blockade device (200), said amplitudes across the spectrum measured indicating the threshold phenomena and rates of motion of electrical charges in the device.

18. The apparatus of claims 1 or 2, said source providing a time varying electrical signal, said signal including components of at least two different frequencies, wherein said at least two frequencies individually or in combination are characteristic of at least two substances; said at least one electrode being for coupling the signal to said at least two substances; and wherein said device substantially simultaneously measures the amplitude changes of the current or voltage across the substances at said at least two frequencies or their harmonics, or their sums and differences or combinations thereof.

19. The apparatus of claim 18, said source including a plurality of signal generators (21n) that each provides an electrical signal with frequencies in a frequency band.

20. The apparatus of claim 19, said generators each comprising an oscillator, wherein said source further comprises a combiner or mixer (302) connecting the oscillators.

21. The apparatus of claim 18, wherein neither of said at least two frequencies is an integral multiple of the other.

22. The apparatus of claim 18, wherein the components of at least two different frequencies cause a pulse of amplitude higher than the amplitudes of the components to occur at a frequency lower than the at least two different frequencies.

23. The apparatus of claim 22, wherein said substances are undergoing electrochemical changes, and wherein said source is such that said pulse alters the electrochemical changes, or is characteristic of substances at the electrode(s) or rates of the electrochemical changes.

24. The apparatus of claim 22, wherein said substances include an array of two or more Coulomb blockade devices with different thresholds, and wherein the source is such that one or more of the components of said at least two frequencies are variable over time, so that the relative amplitudes of current or voltage of the higher harmonics of the difference frequency to the lower harmonics of the difference frequency measured by the circuit indicates one or more of the thresholds of the devices.

25. The apparatus of claim 22, wherein the components combine or mix to form a signal with spikes of a shape determined by the sum of the at least two frequencies, said spikes occurring at a frequency substantially equal to the difference between the at least two frequencies.

26. The apparatus of claim 25, said circuit measuring at the difference frequency of the at least two frequencies to increase signal/noise ratio.

27. The apparatus of claim 18, wherein said substances include two or more Coulomb blockade devices arranged in series or in parallel as a current standard, and wherein said source is such that the two frequencies are different by a small offset, so that the current or voltage measured by said measuring device at said at least two frequencies or their harmonics, or their sums and differences or combinations thereof indicates accuracy of the standard.

28. The apparatus of claim 18, said electrode having a tip spaced apart by vacuum, a gas or fluid from the substance.

29. The apparatus of claim 28, further comprising:
a feedback circuit (310) for deriving an error signal; and
a controller (34) moving the tip or the substances to change the distance between the tip and the substances in response to the error signal in order to reduce the error signal.

30. The apparatus of claim 18, wherein said source provides an AC electrical signal, a DC voltage or current, an AC electrical signal superposed upon a DC voltage or a signal pulse or transient.

31. The apparatus of claim 18, wherein said source provides a signal that is a DC signal, an AC signal, a signal pulse or signal transient or a combination of two or more thereof.

32. A method for detecting a change in amplitude of a current or voltage transmitted through, or reflected from, a substance (26), said change being related to threshold phenomena associated with the substance and/or atomic or molecular spectra of the substance, the method comprising:
providing a time varying electrical input signal to at least one electrode (22, 22a) in the vicinity of the substance; and
measuring amplitude changes of the current or voltage of transmitted or reflected electrical signal at the at least one electrode;
said method **characterised in that** said time varying electrical signal has a frequency in the range of about 1 to 30 GHz and **in that** said amplitude changes are measured substantially simultaneously at two or more frequencies in a predetermined spectrum of frequencies.

33. The method of claim 32 wherein said substance reflects said input signal to generate a reflected signal;
said method comprising measuring amplitude changes of the reflected signal at the at least one electrode.

34. The method of claim 33, wherein said measuring step measures substantially simultaneously the amplitudes of the reflected signal at the electrode over a predetermined spectrum of frequencies.

35. The method of claims 32 or 33, further comprising repeating the signal providing step where the signals provided in the signal providing steps are of different frequencies, and repeating the measuring step at each of said different frequencies of the signal.

36. The method of claims 32 or 33, wherein the amplitude of the signal provided remains substantially unchanged when the signal providing step is repeated.

37. The method of claims 32 or 33, wherein said substance is undergoing electrochemical changes.

38. The method of claim 37, further comprising determining an optimal frequency of the signal for differentiating different surfaces species or for obtaining images of said surfaces.

39. The method of claim 38, wherein said providing step is performed using a tunable source (21) of microwave AC signals, said method further comprising tuning the source to the optimal frequency before said providing step is repeated.

40. The method of claim 39, further comprising scanning the substance when said providing step is repeated in a constant current or constant height mode to obtain an image of the substance.

41. The method of claims 32 or 33, wherein the providing and measuring steps are repeated where the frequency of the electrical signal provided in the providing steps is varied, in order to detect rates of motion of charges in the substance.

42. The method of claim 32 or 33, wherein the frequency of the electrical signal provided in the providing steps is continually reduced, said method further comprising comparing the amplitudes of high harmonics and those of low harmonics measured in the measuring step, when the frequency of the signal provided in the providing step is continually reduced.

43. The method of claims 32 or 33, further comprising repeating the signal providing step where the signals provided in the signal providing steps are of substantially the same frequency but different amplitudes, and repeating the measuring step at each of said different amplitudes of the signal.

44. The method of claim 43, wherein the signal providing step is repeated so that the amplitude of the signal is varied for each providing step compared to the previous providing step, said method further comprising detecting a sudden change in current or voltage at a selected frequency at the electrode when the amplitudes of the signal are varied to detect a threshold of the substance.

45. The method of claim 43, wherein the amplitude of the signal provided in the providing step is continually increased, said method further comprising comparing the amplitudes of high harmonics and those of low harmonics measured by the measuring step, when the amplitude of the signal provided in the providing step is continually increased.

46. The method of claims 32 or 33, wherein said providing step provides a DC signal, an AC signal, a signal pulse, a signal transient, or a combination of two or more thereof.

47. The method of claim 33, wherein said electrode has a tip (22a) and is a component of a scanning tunneling microscope adapted for scanning the substance to obtain an image of the substance, wherein said scanning step is performed by causing the tip of the electrode to scan the substance when said providing step is repeated.

48. The method of claims 32 or 33, said providing step providing a time varying electrical signal, said signal including components of at least two different frequencies, wherein said at least two frequencies individually or in combination are characteristic of said at least two substances; wherein said at least one electrode couples the signal to at least two substances; and wherein said measuring substantially simultaneously measures the amplitudes of the current or voltage at the substances at said at least two frequencies or their harmonics, or their sums and differences or combinations thereof to detect the at least two substances.

49. The method of claim 48, wherein neither of said at least two frequencies provided by the providing step is an integral multiple of the other.

50. The method of claim 48, wherein the components at least two different frequencies provided by the providing step cause a pulse of amplitude higher than the amplitudes of the components to occur at a frequency lower than the at least two different frequencies.

51. The method of claim 50, wherein said substances are undergoing electrochemical changes, and wherein the providing step is such that said pulse alters the electrochemical changes, or is characteristic of substances at the electrode or rates of the electrochemical changes.

52. The method of claim 50, wherein said substances include an array of two or more Coulomb blockade devices (200) with different thresholds, and wherein said providing step is such that one or more of the components of said at least two frequencies are variable over time, so that measuring the relative amplitudes of current or voltage of the higher harmonics of the difference frequency to the lower harmonics of the difference frequency indicates one or more of the thresholds of the devices.

53. The method of claim 48, wherein the providing step combines or mixes the components.

54. The method of claim 53, said providing step forming a signal with spikes of a shape determined by the sum of the at least two frequencies, said spikes occurring at a frequency substantially equal to the difference between the at least two frequencies.

55. The method of claim 54, said measuring step measuring at the difference between the at least two frequencies to increase signal/noise ratio.

56. The method of claim 48, wherein said substances include two or more Coulomb blockade devices (200) arranged in series or parallel as a current standard, and wherein said providing step provides components at two frequencies that are different by a small offset, so that the current or voltage measured by said measuring step at said at least two frequencies or their harmonics, or their sums and differences or the harmonics thereof indicates accuracy of the standard.

57. The method of claim 48, said method employing an electrode having a tip (22a), said providing step including supplying said time varying signal to said electrode and moving the tip of the electrode to a location in contact with or close to the substances.

58. The method of claim 57, said method further comprising:
feeding back an error signal; and
moving the tip or the substances to change the distance between the tip and the substances in response to the error signal in order to reduce the error signal.

59. The method of claim 48, wherein said providing step provides a signal that is a DC signal, and AC signal, a signal pulse or signal transient or a combination of two or more thereof.

## Patentansprüche

1. Erfassungsvorrichtung (20) zum Erfassen einer Änderung in einer Amplitude eines Stromes oder einer Spannung, der/die durch eine Substanz (26) übertragen oder davon reflektiert wird, wobei sich die Änderung auf Schwellenphänome bezieht, die zu der Substanz und/oder atomaren oder molekularen Spektren der Substanz gehören, wobei die Vorrichtung umfasst:
eine Quelle (21) zum Bereitstellen eines sich zeitlich verändernden elektrischen Signals;
wenigstens eine Elektrode (22, 22a) zum Koppen des Signals an eine Substanz; und
eine Einrichtung (30), die mit der wenigstens eine Elektrode verbunden ist, zum Messen der Amplitude des Stroms oder der Spannung eines elektrischen Signal an der wenigstens einen Elektrode;
wobei die Vorrichtung **dadurch gekennzeichnet ist, dass** das elektrische Signal, das von der Quelle bereit gestellt wird, wenigstens eine Frequenz in dem Bereich von ungefähr 1 bis 30 GHz aufweist, und dass die Einrichtung Amplitudenänderungen des Stromes oder der Spannung des elektrischen Signals an der wenigstens einen Elektrode im wesentlichen gleichzeitig bei zwei oder mehreren Frequenzen in einem vorgegebenen Spektrum von Frequenzen misst.

2. Erfassungsvorrichtung nach Anspruch 1, **dadurch gekennzeichnet, dass** die Elektrode ein reflektiertes elektrisches Signal von der Substanz im Ansprechen auf das sich zeitlich verändernde elektrische Signal erfasst, und dass die Einrichtung Amplitudenänderungen des Stromes oder der Spannung des reflektierten elektrischen Signals misst.

3. Vorrichtung nach Anspruch 2, wobei die Messeinrichtung die Amplituden des reflektierten Signal von der Elektrode über einem vorgegebenen Spektrum von Frequenzen misst.

4. Vorrichtung nach Anspruch 3, wobei die Messeinrichtung im wesentlichen gleichzeitig Frequenzen des reflektierten Signals über das vorgegebene Spektrum misst.

5. Vorrichtung nach Anspruch 1, wobei die Quelle eine abstimmbare Quelle zum Bereitstellen des sich zeitlich verändernden elektrischen Signals bei einer gewählten Frequenz ist; und wobei
die Elektrode von der Substanz durch einen Spalt beabstandet ist, wobei die Elektrode das sich zeitlich verändernde elektrische Signal an die Substanz über den Spalt koppelt und über dem Spalt ein reflektiertes elektrisches Signal von der Substanz im Ansprechen auf das eingegebene Signal erfasst.

6. Vorrichtung nach Anspruch 1 bis 2, wobei die Quelle auf irgendeine gewünschte Frequenz innerhalb eines vorgegebenen Bereichs abstimmbar ist.

7. Vorrichtung nach Anspruch 1 bis 2, wobei die Substanz elektrochemische Änderungen durchläuft.

8. Vorrichtung nach den Ansprüchen 1 oder 2, wobei die Quelle abstimmbar ist, um eine Signal bei verschiedenen Frequenzen, aber bei im wesentlichen der gleichen Amplitude, bereitzustellen.

9. Vorrichtung nach Anspruch 1 oder 2, wobei die Quelle umfasst:
eine abstimmbare Quelle zum Bereitstellen des sich zeitlich verändernden elektrischen Signals bei einer gewählten Frequenz.

10. Vorrichtung nach irgendeinem vorangehenden Anspruch, wobei die Messeinrichtung ein Spektrumanalysator, ein Netzwerkanalysator, ein Lock-In-Verstärker, ein Mikrowellen-Übergangsanalysator, der bei einer Frequenz und deren Harmonischen misst, ein Vektor-Voltmeter, oder ein Leistungsmessgerät mit abstimmbaren Filtern ist.

11. Vorrichtung nach den Ansprüchen 1 oder 2, wobei die Elektrode eine Spitze (22a) aufweist, die durch ein Vakuum, ein Gas oder ein Fluid von der Substanz beabstandet ist.

12. Vorrichtung nach Anspruch 11, wobei die Vorrichtung ferner umfasst:
eine Rückkopplungseinrichtung (152) zum Ableiten eines Fehlersignals von dem Strom oder der Spannung oder von dem reflektierten Signal, das durch die Messeinrichtung gemessen wird, und dem Signal, das von der Quelle bereitgestellt wird; und
eine Einrichtung (34) zum Bewegen der Spitze zum Ändern des Abstands zwischen der Spitze und der Substanz im Ansprechen auf das Fehlersignal, um das Fehlersignal zu verringern.

13. Vorrichtung nach den Ansprüchen 1 oder 2, ferner umfassend eine Einrichtung zum Speichern von Amplitudenänderungen, die atomaren oder molekularen Spektren einer bekannten Substanz entsprechen, zum Vergleich mit Amplitudenänderungen, die atomaren oder molekularen Spektren einer unbekannten Substanz entsprechen, die von der Messeinrichtung erfasst wird, um die unbekannte Substanz zu erfassen.

14. Vorrichtung nach Anspruch 13, wobei die Elektrode und die Messeinrichtung Komponenten eines Scantunnelmikroskops sind, das zum Scannen der Substanz ausgelegt ist, um ein Bild der Substanz zu erhalten.

15. Vorrichtung nach den Ansprüchen 1 oder 2, wobei die Quelle ein Gleichstrom(DC)-Signal, ein Wechselstrom(AC)-Signal, einen Signalimpuls, eine Signaltransiente, oder eine Kombination von zwei oder mehreren davon, bereitstellt.

16. Vorrichtung nach den Ansprüchen 1 oder 2, wobei die Substanz elektrochemische Änderungen durchläuft, wobei die Vorrichtung ferner eine elektrochemische Zelle (100), die die Substanz enthält, eine Referenzelektrode, enthält und wobei die Elektrode die Arbeitselektrode der Zelle ist, so dass die Amplitudenänderungen des Stromes oder Spannung über der Arbeitselektrode und einer Referenzelektrode der Zelle oder die Amplitudenänderungen des reflektierten Signals von der Arbeitselektrode, gemessen über dem Spektrum, eine dynamische Information, die die Änderungen betrifft, enthüllen.

17. Vorrichtung nach Anspruch 1, wobei die Substanz eine Isolatorschicht ist, ferner umfassend eine zweite Elektrode zum Koppeln des Signals an die Substanz, und wobei das Paar von Elektroden an der Schicht angebracht ist, um eine Coulomb-Blockadeneinrichtung (200) zu bilden, wobei die Amplituden über dem gemessenen Spektrum die Schwellenphänome und Bewegungsraten von elektrischen Ladungen und in der Einrichtung anzeigen.

18. Vorrichtung nach den Ansprüchen 1 oder 2, wobei die Quelle ein sich zeitlich veränderndes elektrisches Signal bereitstellt, wobei das Signal Komponenten von wenigstens zwei unterschiedlichen Frequenzen einschließt, wobei die wenigstens zwei Frequenzen individuell oder in Kombination charakteristisch für wenigstens zwei Substanzen sind; wobei die wenigstens eine Elektrode zum Koppeln des Signals an die wenigstens zwei Substanzen vorgesehen ist; und wobei die Einrichtung im wesentlichen gleichzeitig die Amplidutenänderungen des Stroms oder der Spannung über den Substanzen bei den wenigstens zwei Frequenzen oder deren Harmonischen oder deren Summen und Differenzen oder Kombinationen davon misst.

19. Vorrichtung nach Anspruch 18, wobei die Quelle eine Vielzahl von Signalgeneratoren (21n) einschließt, die jeweils ein elektrisches Signal mit Frequenzen in einem Frequenzband bereitstellen.

20. Vorrichtung nach Anspruch 19, wobei die Generatoren jeweils einen Oszillator umfassen, wobei die Quelle ferner einen Kombinierer oder Mischer (302) umfasst, der die Oszillatoren verbindet.

21. Vorrichtung nach Anspruch 18, wobei keine der wenigstens zwei Frequenzen ein ganzzahliges Vielfaches der anderen ist.

22. Vorrichtung nach Anspruch 18, wobei die Komponenten von wenigstens zwei unterschiedlichen Frequenzen bewirken, dass ein Impuls mit einer Amplitude höher als die Amplituden der Komponenten bei einer Frequenz niedriger als die wenigstens zwei unterschiedlichen Frequenzen auftritt.

23. Vorrichtung nach Anspruch 22, wobei die Substanzen elektrochemische Änderungen durchlaufen, und wobei die Quelle derart ist, dass der Impuls die elektrochemischen Änderungen verändert, oder charakteristisch für Substanzen an der Elektrode (den Elektroden) oder Raten der elektrochemischen Änderungen ist.

24. Vorrichtung nach Anspruch 22, wobei die Substanzen ein Feld von zwei oder mehreren Coulomb-Blockadeeinrichtungen mit unterschiedlichen Schwellen einschließen, und wobei die Quelle derart ist, dass eine oder mehrere der Komponenten der wenigstens zwei Frequenzen über der Zeit variabel sind, so dass die relativen Amplituden des Stroms oder der Spannung der höheren Harmonischen der Differenzfrequenz zu den niedrigeren Harmonischen der Differenzfrequenz, gemessen von der Schaltung, ein oder mehrere der Schwellen der Einrichtungen anzeigen.

25. Vorrichtung nach Anspruch 22, wobei die Komponenten kombiniert oder gemischt werden, um ein Signal mit Spitzen einer Form, die durch die Summe der wenigstens zwei Frequenzen bestimmt ist, zu bilden, wobei die Spitzen bei einer Frequenz auftreten, die im wesentlichen gleich zu der Differenz zwischen den wenigstens zwei Frequenzen ist.

26. Vorrichtung nach Anspruch 25, wobei die Schaltung bei der Differenzfrequenz der wenigstens zwei Frequenzen misst, um ein Signal/Rausch-Verhältnis zu erhöhen.

27. Vorrichtung nach Anspruch 18, wobei die Substanzen zwei oder mehrere Coulomb-Blockadeeinrichtungen einschließen, die in Serie oder parallel als ein gegenwärtiger Standard angeordnet sind, und wobei die Quelle derart ist, dass die zwei Frequenzen um einen kleinen Versatz unterschiedlich sind, so dass der Strom oder die Spannung, der/die von der Messeinrichtungen bei den wenigstens zwei Frequenzen oder deren Harmonischen gemessen wird, oder deren Summen und Differenzen oder Kombinationen davon eine Genauigkeit des Standards anzeigt.

28. Vorrichtung nach Anspruch 18, wobei die Elektrode eine Spitze aufweist, die durch eine Vakuum, ein Gas oder ein Fluid von der Substanz beabstandet ist.

29. Vorrichtung nach Anspruch 28, ferner umfassend:
eine Rückkoppelschaltung (310) zum Ableiten eines Fehlersignals; und
einen Controller (34), der die Spitze oder die Substanzen zum Verändern des Abstands zwischen der Spitze und den Substanzen im Ansprechen auf das Fehlersignal bewegt, um das Fehlersignal zu verringern.

30. Vorrichtung nach Anspruch 18, wobei die Quelle ein elektrisches Wechselstrom(AC)-Signal, eine Gleich(DC)-Spannung oder einen Gleich(DC)-Strom, ein elektrisches Wechselstrom(AC)-Signal überlagert auf eine Gleich(DC)-Spannung oder einen Signalimpuls oder eine Transiente bereitstellt.

31. Vorrichtung nach Anspruch 18, wobei die Quelle ein Signal bereitstellt, das ein Gleichstrom(DC)-Signal, ein Wechselstrom(AC)-Signal, ein Signalimpuls oder eine Singaltransiente oder eine Kombinaten von zwei oder mehreren ist.

32. Verfahren zum Erfassen einer Änderung in der Amplitude eines Stromes oder einer Spannung, der/die durch eine Substanz (26) übertragen oder davon reflektiert wird, wobei sich die Änderungen auf Schwellenphänome bezieht, die zu der Substanz und/oder atomaren oder molekularen Spektren der Substanz gehören, wobei das Verfahren die folgenden Schritte umfasst:
Bereitstellen eines sich zeitlich verändernden elektrischen Eingangssignals an wenigstens einer Elektrode (22, 22a) in der Nähe der Substanz;
Messen von Amplitudenänderungen des Stromes oder der Spannung des übertragenen oder reflektierten elektrischen Signals an der wenigstens eine Elektrode;
wobei das Verfahren **dadurch gekennzeichnet ist, dass** das sich zeitlich verändernde elektrische Signal eine Frequenz in dem Bereich ungefähr 1 bis 30 GHz aufweist und dass die Amplitudenänderungen im wesentlichen gleichzeitig bei zwei oder mehreren Frequenzen in einem vorgebenden Spektrum von Frequenzen gemessen werden.

33. Verfahren nach Anspruch 32, wobei die Substanz das Eingangssignal reflektiert, um ein reflektiertes Signal zu erzeugen;
wobei das Verfahren das Messen von Amplitudenänderungen des reflektierten Signals an der wenigstens einen Elektrode umfasst.

34. Verfahren nach Anspruch 33, wobei der Messschritt im wesentlichen gleichzeitig die Amplituden des reflektierten Signals an der Elektrode über einem vorgebenden Spektrum von Frequenzen misst.

35. Verfahren nach den Ansprüchen 32 oder 33, ferner umfassend das Wiederholen des Signalbereitsstellungsschritts, wobei die Signale, die in den Signalbereitstellungsschritten bereitgestellt werden, von unterschiedlichen Frequenzen sind, und das Wiederholen des Messschritts bei jeder der verschiedenen Frequenzen des Signals.

36. Verfahren nach den Ansprüchen 32 oder 33, wobei die Amplitude des Signals, das bereitgestellt wird, im wesentlichen unverändert bleibt, wenn der Signalbereitstellungsschritt wiederholt wird.

37. Verfahren nach den Ansprüchen 32 oder 33, wobei die Substanz elektrochemische Veränderungen durchläuft.

38. Verfahren nach Anspruch 37, ferner umfassend das Bestimmen einer optimalen Frequenz des Signals zum Unterscheiden von unterschiedlichen Oberflächenarten oder zum Erhalten von Bildern der Oberflächen.

39. Verfahren nach Anspruch 38, wobei der Bereitstellungsschritt unter Verwendung einer abstimmbaren Quelle (21) von Mikrowellen-Wechselstrom(AC)-Signalen ausgeführt wird, wobei das Verfahren ferner das Abstimmen der Quelle auf die optimale Frequenz, bevor der Bereitstellungsschritt wiederholt wird, umfasst.

40. Verfahren nach Anspruch 39, ferner umfassend das Scannen der Substanz, wenn der Bereitstellungsschritt in einem Modus mit einem konstanten Strom oder einer konstanten Höhe wiederholt wird, um ein Bild der Substanz zu erhalten.

41. Verfahren nach den Ansprüchen 32 oder 33, wobei die Bereitstellungs- und Messschritte wiederholt werden, wobei die Frequenz des elektrischen Signals, das in den Bereitstellungsschritten bereitgestellt wird, verändert wird, um Bewegungsraten von Ladungen in der Substanz zu erfassen.

42. Verfahren nach Anspruch 32 oder 33, wobei die Frequenz des elektrischen Signals, das in den Bereitstellungsschritten bereitgestellt wird, kontinuierlich verringert wird, wobei das Verfahren ferner das Vergleichen der Amplituden von hohen Harmonischen mit denjenigen von niedrigen Harmonischen, die in dem Messschritt gemessen werden, wenn die Frequenz des in den Bereitstellungsschritt bereitgestellten Signals kontinuierlich verringert wird, umfasst.

43. Verfahren nach den Ansprüchen 32 oder 33, ferner umfassend das Wiederholen des Signalbereitstellungsschrittes, wobei die in den Signalbereitstellungsschritten bereitgestellten Signale von im wesentlichen der gleichen Frequenz, aber mit unterschiedlichen Amplituden, sind und das Wiederholen des Messschrittes bei jeder der verschiedenen Amplituden des Signals.

44. Verfahren nach Anspruch 43, wobei der Signalbereitstellungsschritt so wiederholt wird, dass die Amplitude des Signals für jeden Bereitstellungsschritt im Vergleich mit dem vorangehenden Bereitstellungsschritt verändert wird, wobei das Verfahren ferner das Erfassen einer plötzlichen Änderung in dem Strom oder der Spannung bei einer gewählten Frequenz an der Elektrode, wenn die Amplituden des Signals verändert werden, um eine Schwelle der Substanz zu erfassen, umfasst.

45. Verfahren nach Anspruch 43, wobei die Amplitude des Signals, das in den Bereitstellungsschritt bereitgestellt wird, kontinuierlich erhöht wird, wobei das Verfahren ferner das Vergleichen der Amplituden von hohen Harmonischen mit denjenigen von niederen Harmonischen, die von dem Messschritt gemessen werden, wenn die Amplitude des in den Bereitstellungsschritt bereitgestellten Signals kontinuierlich erhöht wird, umfasst.

46. Verfahren nach den Ansprüchen 32 oder 33, wobei der Bereitstellungsschritt ein Gleichstrom(DC)-Signal, ein Wechselstrom(AC)-Signal, einen Signalimpuls, eine Singaltransiente, oder eine Kombination von zwei oder mehreren davon bereitstellt.

47. Verfahren nach Anspruch 33, wobei die Elektrode eine Spitze (22a) aufweist und eine Komponente eines Scantunnelmikroskops ist, das zum Scannen der Substanz ausgelegt ist, um ein Bild der Substanz zu erhalten, wobei der Scanschritt ausgeführt wird, indem die Spitze der Elektrode veranlasst wird, die Substanz abzuscannen, wenn der Bereitstellungsschritt wiederholt wird.

48. Verfahren nach den Ansprüchen 32 oder 33, wobei der Bereitstellungsschritt ein sich zeitlich veränderndes elektrisches Signal bereitstellt, wobei das Signal Komponenten von wenigstens zwei verschiedenen Frequenzen einschließt, wobei die wenigstens zwei Frequenzen individuell oder in Kombination charakteristisch für die wenigstens zwei Substanzen sind; wobei die wenigstens eine Elektrode das Signal an wenigstens zwei Substanzen koppelt; und wobei das Messen im wesentlichen gleichzeitig die Amplituden des Stroms oder der Spannung an den Substanzen bei den wenigstens zwei Frequenzen oder deren Harmonischen oder deren Summen und Differenzen oder Kombinationen davon misst, um die wenigstens zwei Substanzen zu erfassen.

49. Verfahren nach Anspruch 48, wobei keine der wenigstens zwei Frequenzen, die von dem Bereitstellungsschritt bereitgestellt werden, ein ganzzahliges Vielfaches der anderen ist.

50. Verfahren nach Anspruch 48, wobei die Komponenten bei den wenigstens zwei Frequenzen, die von dem Bereitstellungsschritt bereitgestellt werden, bewirken, dass ein Impuls mit einer Amplitude höher als die Amplitude der Komponenten bei einer Frequenz niedriger als die wenigstens zwei unterschiedlichen Frequenzen auftritt.

51. Verfahren nach Anspruch 50, wobei die Substanzen elektrochemische Änderungen durchlaufen, und wobei der Bereitstellungsschritt derart ist, dass der Impuls die elektrochemischen Änderungen verändert, oder charakteristisch für Substanzen an der Elektrode oder Raten der elektrochemischen Änderungen ist.

52. Verfahren nach Anspruch 50, wobei die Substanzen ein Feld von zwei oder mehreren Coulomb-Blockadeeinrichtungen (200) mit unterschiedlichen Schwellen einschließen, und wobei der Bereitstellungsschritt derart ist, dass eine oder mehrere der Komponenten der wenigstens zwei Frequenzen über der Zeit variabel sind, so dass ein Messen der relativen Amplituden des Stromes oder der Spannungen der höheren Harmonischen der Differenzfrequenz zu den niedrigeren Harmonischen der Differenzfrequenz eine oder mehrere der Schwellen der Einrichtungen anzeigt.

53. Verfahren nach Anspruch 48, wobei der Bereitstellungsschritt die Komponenten kombiniert oder mischt.

54. Verfahren nach Anspruch 53, wobei der Bereitstellungsschritt ein Signal mit Spitzen einer Form bildet, die durch die Summe der wenigstens zwei Frequenzen bestimmt ist, wobei die Spitzen bei einer Frequenz im wesentlichen gleich zu der Differenz zwischen den wenigstens zwei Frequenzen auftreten.

55. Verfahren nach Anspruch 54, wobei der Messschritt bei der Differenz zwischen den wenigstens zwei Frequenzen misst, um ein Signal/Rausch-Verhältnis zu erhöhen.

56. Verfahren nach Anspruch 48, wobei die Substanzen zwei oder mehrere Coulomb-Blockadeeinrichtungen (200) einschließen, die in Serie oder parallel als ein gegenwärtiger Standard angeordnet sind, und wobei der Bereitstellungsschritt Komponenten bei zwei Frequenzen bereitstellt, die um einen kleinen Versatz unterschiedlich sind, so dass der Strom oder die Spannung, der/die von dem Messschritt bei den wenigstens zwei Frequenzen oder deren Harmonischen, oder deren Summen und Differenzen oder den Harmonischen davon gemessen wird, eine Genauigkeit des Standards anzeigt.

57. Verfahren nach Anspruch 48, wobei das Verfahren eine Elektrode verwendet, die eine Spitze (22a) aufweist, wobei der Bereitstellungsschritt das Zuführen des sich zeitlich verändernden Signals an die Elektrode und das Bewegen der Spitze der Elektrode an einen Ort in Kontakt mit oder nahe zu den Substanzen einschließt.

58. Verfahren nach Anspruch 57, wobei das Verfahren ferner umfasst:
Rückkoppeln eines Fehlersignals; und
Bewegen der Spitze oder der Substanzen zum Ändern des Abstandes zwischen der Spitze und den Substanzen im Ansprechen auf das Fehlersignal, um das Fehlersignal zu verringern.

59. Verfahren nach Anspruch 48, wobei der Bereitstellungsschritt ein Signal bereitstellt, dass ein Gleichstrom(DC)-Signal, und ein Wechselstrom(AC)-Signal, ein Signalimpuls oder eine Signaltransiente oder eine Kombination von zwei oder mehreren davon ist.

## Revendications

1. Appareil de détection (20) pour détecter une variation d'amplitude d'un courant ou d'une tension transmis(e) au travers d'une substance (26) ou réfléchi(e) depuis cette même substance, ladite variation étant rapportée à des phénomènes de seuil qui sont associés à la substance et/ou à des spectres atomiques ou moléculaires de la substance, l'appareil comprenant:
une source (21) pour-produire un signal électrique variant temporellement;
au moins une électrode (22, 22a) pour coupler ledit signal à une substance; et
un dispositif (30) qui est connecté à l'au moins une électrode pour mesurer l'amplitude du courant ou de la tension d'un signal électrique au niveau de l'au moins une électrode, ledit appareil étant **caractérisé en ce que** le signal électrique qui est produit par la source présente au moins une fréquence dans la plage qui va d'environ 1 GHz à environ 30 GHz, et **en ce que** le dispositif mesure des variations d'amplitude du courant ou de la tension du signal électrique au niveau de l'au moins une électrode sensiblement simultanément à deux fréquences ou plus dans un spectre de fréquences prédéterminé.

2. Appareil de détection selon la revendication 1, **caractérisé en ce que** l'électrode détecte un signal électrique réfléchi depuis la substance en réponse audit signal électrique variant temporellement et **en ce que** le dispositif mesure des variations d'amplitude du courant ou de la tension du signal électrique réfléchi.

3. Appareil selon la revendication 2, ledit dispositif de mesure mesure les amplitudes du signal électrique réfléchi à partir de l'électrode sur un spectre de fréquences prédéterminé.

4. Appareil selon la revendication 3, ledit dispositif de mesure mesurant des fréquences du signal réfléchi sur ledit spectre prédéterminé sensiblement simultanément.

5. Appareil selon la revendication 1, dans lequel ladite source est une source accordable pour produire ledit signal électrique variant temporellement à une fréquence sélectionnée; et dans lequel ladite électrode est espacée de la substance par un espace, ladite électrode couplant le signal électrique variant temporellement sur la substance au travers de l'espace et détectant au travers dudit espace un signal électrique réfléchi à partir de la substance en réponse audit signal d'entrée.

6. Appareil selon la revendication 1 ou 2, ladite source étant accordable sur n'importe quelle fréquence souhaitée à l'intérieur d'une plage prédéterminée.

7. Appareil selon la revendication 1 ou 2, dans lequel ladite substance est en train de subir des modifications électrochimiques.

8. Appareil la revendication 1 ou 2, dans lequel ladite source peut être accordée pour produire un signal à des fréquences différentes mais de sensiblement la même amplitude.

9. Appareil selon la revendication 1 ou 2, dans lequel ladite source comprend une source accordable pour produire ledit signal électrique variant temporellement à une fréquence sélectionnée.

10. Appareil selon l'une quelconque des revendications précédentes, dans lequel ledit dispositif de mesure est un analyseur de spectre, un analyseur de réseau, un amplificateur synchrone, un analyseur de transition micro-ondes ou hyperfréquences qui réalise une mesure à une fréquence et à ses harmoniques, un voltmètre vectoriel ou un dispositif de mesure de puissance avec des filtres accordables.

11. Appareil selon la revendication 1 ou 2, ladite électrode comportant une pointe (22a) qui est espacée de la substance par un vide, un gaz ou un fluide.

12. Appareil selon la revendication 11, ledit appareil comprenant en outre:
un moyen de retour (152) pour dériver un signal d'erreur à partir du courant ou de la tension ou d'un signal réfléchi qui est mesuré par le dispositif de mesure et à partir du signal qui est produit par la source; et
un moyen (34) pour déplacer la pointe afin de modifier la distance entre la pointe et la substance en réponse au signal d'erreur afin de réduire le signal d'erreur.

13. Appareil selon la revendication 1 ou 2, comprenant en outre un moyen pour stocker des variations d'amplitude correspondant à des spectres atomiques ou moléculaires d'une substance connue en vue d'une comparaison avec des variations d'amplitude correspondant à des spectres atomiques ou moléculaires d'une substance inconnue comme détecté au moyen du dispositif de mesure pour détecter la substance inconnue.

14. Appareil selon la revendication 13, dans lequel ladite électrode et ledit dispositif de mesure sont des composants d'un microscope à effet tunnel à balayage qui est adapté pour balayer la substance pour obtenir une image de la substance.

15. Appareil selon la revendication 1 ou 2, dans lequel ladite source fournit un signal DC, un signal AC, une impulsion de signal, un phénomène transitoire de signal ou une combinaison de deux ou plus de ces éléments.

16. Appareil selon la revendication 1 ou 2, dans lequel ladite substance est en train de subir des variations électrochimiques, ledit appareil comprenant en outre une cellule électrochimique (100) qui contient la substance et une électrode de référence et dans lequel ladite électrode est l'électrode de travail de la cellule de telle sorte que les variations d'amplitude du courant ou de la tension aux travers de l'électrode de travail et d'une électrode de référence de la cellule ou que les variations d'amplitude du signal réfléchi depuis l'électrode de travail, comme mesuré sur ledit spectre, révèlent une information dynamique concernant les variations.

17. Appareil selon la revendication 1, dans lequel ladite substance est une couche isolante, comprenant en outre une seconde électrode pour coupler le signal à la substance et dans lequel les électrodes de la paire d'électrodes sont liées à la couche de manière à former un dispositif de blocage de Coulomb (200), lesdites amplitudes sur le spectre comme mesuré indiquant les phénomènes de seuil et les vitesses de déplacement de charges électriques dans le dispositif.

18. Appareil selon la revendication 1 ou 2, ladite source produisant un signal électrique variant temporellement, ledit signal incluant des composantes d'au moins deux fréquences différentes, dans lequel lesdites au moins deux fréquences, de façon individuelle ou en combinaison, sont caractéristiques d'au moins deux substances, ladite au moins une électrode étant pour coupler le signal auxdites au moins deux substances; et dans lequel ledit dispositif mesure de façon sensiblement simultanée les variations d'amplitude du courant ou de la tension au travers des substances auxdites au moins deux fréquences ou à leurs harmoniques, ou leurs sommes et leurs différences ou des combinaisons afférentes.

19. Appareil selon la revendication 18, ladite source incluant une pluralité de générateurs de signal (21n), qui produisent chacun un signal électrique avec des fréquences dans une bande de fréquences.

20. Appareil selon la revendication 19, lesdits générateurs comprenant chacun un oscillateur, dans lequel ladite source comprend en outre un combineur ou un mélangeur (302) connectant les oscillateurs.

21. Appareil selon la revendication 18, dans lequel aucune desdites au moins deux fréquences n'est un multiple entier de l'autre.

22. Appareil selon la revendication 18, dans lequel les composantes d'au moins deux fréquences différentes ont pour effet qu'une impulsion d'amplitude supérieure aux amplitudes des composantes se produit à une fréquence inférieure aux au moins deux fréquences différentes.

23. Appareil selon la revendication 22, dans lequel lesdites substances sont en train de subir des variations électrochimiques et dans lequel ladite source est telle que ladite impulsion altère les variations électrochimiques ou est caractéristique de substances au niveau de l'électrode ou au niveau des électrodes ou de vitesses des variations électrochimiques.

24. Appareil selon la revendication 22, dans lequel lesdites substances incluent un réseau de deux dispositifs de blocage de Coulomb ou plus avec des seuils différents et dans lequel la source est telle que une ou plusieurs des composantes desdites au moins deux fréquences sont variables sur le temps de telle sorte que les amplitudes relatives de courant ou de tension des harmoniques d'ordre plus élevé de la fréquence de différence par rapport aux harmoniques d'ordre plus faible de la fréquence de différence comme mesuré par le circuit indiquent un ou plusieurs des seuils des dispositifs.

25. Appareil selon la revendication 22, dans lequel les composantes se combinent ou se mélangent pour former un signal avec des pics d'une forme qui est déterminée par la somme des au moins deux fréquences, lesdits pics survenant à une fréquence qui est sensiblement égale à la différence entre les au moins deux fréquences.

26. Appareil selon la revendication 25, ledit circuit effectuant une mesure à la fréquence de différence des au moins deux fréquences afin d'augmenter un rapport signal/bruit.

27. Appareil selon la revendication 18, dans lequel lesdites substances incluent deux dispositifs de blocage de Coulomb ou plus qui sont agencés en série ou en parallèle en tant que standard courant et dans lequel ladite source est telle que les deux fréquences sont différentes d'un petit décalage de telle sorte que le courant ou la tension qui est mesuré(e) par ledit dispositif de mesure auxdites au moins deux fréquences ou à leurs harmoniques ou à leurs sommes et à leurs différences ou à des combinaisons afférentes indique la précision du standard.

28. Appareil selon la revendication 18, ladite électrode comportant une pointe espacée de la substance par un vide, un gaz ou un fluide.

29. Appareil selon la revendication 28, comprenant en outre:
un circuit de retour (310) pour dériver un signal d'erreur; et
un contrôleur (34) qui déplace la pointe ou les substances afin de modifier la distance entre la pointe et les substances en réponse au signal d'erreur afin de réduire le signal d'erreur.

30. Appareil selon la revendication 18, dans lequel ladite source applique un signal électrique AC, une tension ou un courant DC, un signal électrique AC superposé sur une tension DC ou une impulsion de signal ou un phénomène transitoire de signal.

31. Appareil selon la revendication 18, dans lequel ladite source applique un signal qui est un signal DC, un signal AC, une impulsion de signal ou un phénomène transitoire de signal ou une combinaison de deux ou plus de ces éléments.

32. Procédé permettant de détecter une variation d'amplitude d'un courant ou d'une tension transmis(e) au travers d'une substance (26) ou réfléchi(e) depuis cette même substance, ladite variation étant rapportée à des phénomènes de seuil qui sont associés à la substance et/ou à des spectres atomiques ou moléculaires de la substance, le procédé comprenant:
l'application d'un signal d'entrée électrique variant temporellement sur au moins une électrode (22, 22a) au voisinage de la substance; et
la mesure de variations d'amplitude du courant ou de la tension d'un signal électrique transmis ou réfléchi au niveau de l'au moins une électrode,
ledit procédé étant **caractérisé en ce que** ledit signal électrique variant temporellement présente une fréquence dans la plage qui va d'environ 1 GHz à environ 30 GHz et **en ce que** lesdites variations d'amplitude sont mesurées sensiblement simultanément à deux fréquences ou plus dans un spectre de fréquences prédéterminé.

33. Procédé selon la revendication 32, dans lequel ladite substance réfléchit ledit signal d'entrée pour générer un signal réfléchi, ledit procédé comprenant la mesure de variations d'amplitude du signal réfléchi au niveau de l'au moins une électrode.

34. Procédé selon la revendication 33, dans lequel ladite étape de mesure mesure sensiblement simultanément les amplitudes du signal réfléchi au niveau de l'électrode sur un spectre de fréquences prédéterminé.

35. Procédé selon la revendication 32 ou 33, comprenant en outre la répétition de l'étape d'application de signal où les signaux appliqués au niveau des étapes d'application de signal sont de différentes fréquences, et la répétition de l'étape de mesure au niveau de chacune desdites différentes fréquences du signal.

36. Procédé selon la revendication 32 ou 33, dans lequel l'amplitude du signal appliqué reste sensiblement inchangée lorsque l'étape d'application de signal est répétée.

37. Procédé selon la revendication 32 ou 33, dans lequel ladite substance est en train de subir des variations électrochimiques.

38. Procédé selon la revendication 37, comprenant en outre la détermination d'une fréquence optimum du signal pour différencier différentes espèces de surfaces ou pour obtenir des images desdites surfaces.

39. Procédé selon la revendication 38, dans lequel ladite étape d'application est réalisée en utilisant une source accordable (21) de signaux AC micro-ondes ou hyperfréquences, ledit procédé comprenant en outre l'accord de la source sur la fréquence optimum avant que ladite étape d'application ne soit répétée.

40. Procédé selon la revendication 39, comprenant en outre le balayage de la substance lorsque ladite étape d'application est répétée dans un mode courant constant ou hauteur constante pour obtenir une image de la substance.

41. Procédé selon la revendication 32 ou 33, dans lequel les étapes d'application et de mesure sont répétées, étapes au niveau desquelles la fréquence du signal électrique appliqué au niveau des étapes d'application est modifiée afin de détecter des vitesses de déplacement de charges dans la substance.

42. Procédé selon la revendication 32 ou 33, dans lequel la fréquence du signal électrique appliqué au niveau des étapes d'application est réduite en continu, ledit procédé comprenant en outre la comparaison des amplitudes d'harmoniques d'ordre élevé et celles d'harmoniques d'ordre faible comme mesuré au niveau de l'étape de mesure lorsque la fréquence du signal appliqué au niveau de l'étape d'application est réduite en continu.

43. Procédé selon la revendication 32 ou 33, comprenant en outre la répétition de l'étape d'application de signal au niveau de laquelle les signaux appliqués au niveau des étapes d'application de signal sont de sensiblement la même fréquence mais d'amplitudes différentes, et la répétition de l'étape de mesure pour chacune desdites différentes amplitudes du signal.

44. Procédé selon la revendication 43, dans lequel l'étape d'application de signal est répétée de telle sorte que l'amplitude du signal soit modifiée pour chaque étape d'application par comparaison avec l'étape d'application précédente, ledit procédé comprenant en outre la détection d'une variation soudaine du courant ou de la tension à une fréquence sélectionnée au niveau de l'électrode lorsque les amplitudes du signal sont modifiées pour détecter un seuil de la substance.

45. Procédé selon la revendication 43, dans lequel l'amplitude du signal appliqué au niveau de l'étape d'application est augmentée en continu, ledit procédé comprenant en outre la comparaison des amplitudes d'harmoniques d'ordre élevé et de celles d'harmoniques d'ordre faible comme mesuré par l'étape de mesure, lorsque l'amplitude du signal qui est appliqué au niveau de l'étape d'application est augmentée en continu.

46. Procédé selon la revendication 32 ou 33, dans lequel ladite étape d'application applique un signal DC, un signal AC, une impulsion de signal ou un phénomène transitoire de signal ou une combinaison de deux ou plus de ces éléments.

47. Procédé selon la revendication 33, dans lequel ladite électrode comporte une pointe (22a) et est un composant d'un microscope à effet tunnel à balayage qui est adapté pour balayer la substance afin d'obtenir une image de la substance, dans lequel ladite étape de balayage est réalisée en faisant en sorte que la pointe de l'électrode balaie la substance lorsque ladite étape d'application est répétée.

48. Procédé selon la revendication 32 ou 33, ladite étape d'application appliquant un signal électrique variant temporellement, ledit signal incluant des composantes d'au moins deux fréquences différentes, dans lequel lesdites au moins deux fréquences, de façon individuelle ou en combinaison, sont caractéristiques desdites au moins deux substances; dans lequel ladite au moins une électrode couple le signal aux au moins deux substances; et dans lequel ladite mesure mesure sensiblement simultanément les amplitudes du courant ou de la tension au niveau des substances auxdites au moins deux fréquences ou à leurs harmoniques, et leurs sommes et leurs différences ou des combinaisons afférentes afin de détecter les au moins deux substances.

49. Procédé selon la revendication 48, dans lequel aucune desdites au moins deux fréquences appliquées par l'étape d'application n'est un multiple entier de l'autre.

50. Procédé selon la revendication 48, dans lequel les composantes aux au moins deux fréquences différentes appliquées par l'étape d'application ont pour effet qu'une impulsion d'une amplitude supérieure à l'amplitude des composantes se produit à une fréquence inférieure aux au moins deux fréquences différentes.

51. Procédé selon la revendication 50, dans lequel lesdites substances sont en train de subir des variations électrochimiques et dans lequel l'étape d'application est telle que ladite impulsion altère les variations électrochimiques ou est caractéristique de substances au niveau de l'électrode ou de taux des variations électrochimiques.

52. Procédé selon la revendication 50, dans lequel lesdites substances incluent un réseau de deux dispositifs de blocage de Coulomb (200) ou plus avec des seuils différents et dans lequel ladite étape d'application est telle qu'une ou plusieurs des composantes desdites au moins deux fréquences sont variables sur le temps de telle sorte que la mesure des amplitudes relatives de courant ou de tension des harmoniques d'ordre supérieur de la fréquence de différence par rapport aux harmoniques d'ordre inférieur de la fréquence de différence indique un ou plusieurs des seuils des dispositifs.

53. Procédé selon la revendication 48, dans lequel l'étape d'application combine ou mélange les composantes.

54. Procédé selon la revendication 53, ladite étape d'application formant un signal avec des pics d'une forme qui est déterminée par la somme des au moins deux fréquences, lesdits pics survenant à une fréquence qui est sensiblement égale à la différence entre les au moins deux fréquences.

55. Procédé selon la revendication 54, ladite étape de mesure mesurant la différence entre les au moins deux fréquences afin d'augmenter un rapport signal/bruit.

56. Procédé selon la revendication 48, dans lequel lesdites substances incluent deux dispositifs de blocage de Coulomb (200) ou plus qui sont agencés en série ou en parallèle en tant que standard courant et dans lequel ladite étape d'application applique des composantes à deux fréquences qui sont différentes d'un petit décalage de telle sorte que le courant ou la tension mesuré(e) par ladite étape de mesure auxdites au moins deux fréquences ou à leurs harmoniques, ou à leurs sommes et à leurs différences ou aux harmoniques afférents indique la précision du standard.

57. Procédé selon la revendication 48, ledit procédé utilisant une électrode qui comporte une pointe (22a), ladite étape d'application incluant l'application dudit signal variant temporellement sur ladite électrode et le déplacement de la pointe de l'électrode jusqu'à une localisation en contact avec les substances ou à proximité de celles-ci.

58. Procédé selon la revendication 57, ledit procédé comprenant en outre:
l'application en retour d'un signal d'erreur; et
le déplacement de la pointe ou des substances afin de modifier la distance entre la pointe et les substances en réponse au signal d'erreur afin de réduire le signal d'erreur.

59. Procédé selon la revendication 48, dans lequel ladite étape d'application applique un signal qui est un signal DC, un signal AC, une impulsion de signal ou un phénomène transitoire de signal ou une combinaison de deux ou plus de ces éléments.
